# EUROPEAN PATENT SPECIFICATION

(11) **EP 4 459 142 B1**
(45) Date of publication and mention of the grant of the patent: **17.12.2025**
(21) Application number: 23838478.8
(22) Date of filing: 17.04.2023
(51) Int. Cl.: F16C 11/04, H04M 1/02, G06F 1/16

(54) **ROTATING SHAFT MECHANISM AND FOLDABLE TERMINAL DEVICE**
DREHWELLENMECHANISMUS UND KLAPPBARES ENDGERÄT
MÉCANISME D'ARBRES ROTATIFS ET DISPOSITIF TERMINAL PLIABLE

(30) Priority: 13.07.2022 CN 202210827273
(43) Date of publication of application: 06.11.2024
(73) Proprietor: Honor Device Co., Ltd., Shenzhen, Guangdong 518040 (CN)
(72) Inventor: JIANG, Xiaoyao, Shenzhen, Guangdong 518040 (CN); YAO, Wenxing, Shenzhen, Guangdong 518040 (CN); ZHANG, Yaolei, Shenzhen, Guangdong 518040 (CN); ZHENG, Hansen, Shenzhen, Guangdong 518040 (CN)
(74) Representative: MERH-IP Matias Erny Reichl Hoffmann Patentanwälte PartG mbB
(86) International application number: PCT/CN2023/088629
(87) International publication number: WO 2024/011977

(56) References cited:
- CN-A- 110 007 715
- CN-A- 113 009 967
- CN-A- 114 076 144
- CN-A- 114 738 370
- CN-B- 111 357 261
- US-A1- 2009 000 062
- US-A1- 2015 233 162

## Description

This application claims priority to Chinese Patent Application No. 202210827273.8, filed with the China National Intellectual Property Administration on July 13, 2022 and entitled "ROTATING SHAFT MECHANISM AND FOLDABLE TERMINAL DEVICE".

### TECHNICAL FIELD

This application relates to a rotating shaft mechanism and a foldable terminal device.

### BACKGROUND

A foldable terminal device has two poses: unfolded and folded. A rotating shaft mechanism is an important component for unfolding and folding the foldable terminal device. In a process in which the foldable terminal device is switched from an unfolded state to a folded state or from a folded state to an unfolded state, a transmission mechanism inside the rotating shaft mechanism is prone to a problem during transmission, and this not only affects user experience, but also shortens a service life of a part.
Document CN 111357261B relates to a rotating shaft connection mechanism. The mechanism includes two rotating shafts, two connection assemblies corresponding to the respective rotating shafts, and a synchronous drive block. Each connection assembly comprises a sliding block and a drive piece, wherein a boss formed on the sliding block is inserted into an inclined groove of the drive piece. The synchronous drive block is operatively connected to both rotating shafts, enabling synchronized rotation.

### SUMMARY

Embodiments of this application provide a rotating shaft mechanism and a foldable terminal device, to resolve a problem of abnormal sound that is caused by collision between parts when the rotating shaft mechanism rotates. The present invention is defined by the appended claims. In the following, parts of the description and drawings referring to former embodiments which do not necessarily comprise all features to implement embodiments of the claimed invention are understood to not represent embodiments of the invention but to relate to be examples useful for understanding the embodiments of the invention.

An embodiment of this application provides a rotating shaft mechanism, including a rotating shaft base, a shaft cover assembly, a rotating shaft, a centrifugal part, and a limiting member. The shaft cover assembly is disposed on a side of the rotating shaft base in a thickness direction of the rotating shaft base, and an accommodating groove is disposed in the shaft cover assembly. The rotating shaft is rotatably disposed on the rotating shaft base. The centrifugal part is fixedly disposed at one end of the rotating shaft, and the centrifugal part deviates from an axis of the rotating shaft. The centrifugal part is rotatably disposed in the accommodating groove and is in clearance fit with the accommodating groove. When the rotating shaft rotates, the rotating shaft drives, by using the centrifugal part, the shaft cover assembly to move in the thickness direction of the rotating shaft base. The limiting member is at least partially located in the accommodating groove. The limiting member is configured to abut against the centrifugal part in rotation.

In this embodiment, when the rotating shaft rotates, the centrifugal part can be driven to rotate in the accommodating groove around the axis of the rotating shaft. Rotation of the centrifugal part can drive the shaft cover assembly to move in the thickness direction of the rotating shaft base. The limiting member is at least partially located in the accommodating groove, and can abut against the centrifugal part when the centrifugal part rotates. Therefore, when the centrifugal part rotates, the limiting member can fill at least a gap between the accommodating groove and the centrifugal part. When the centrifugal part rotates, the centrifugal part can limit rotation or displacement of the limiting member relative to an inner wall of the accommodating groove, thereby reducing abnormal sound.

In an embodiment, the limiting member includes a first limiting layer, the first limiting layer is disposed on the inner wall of the accommodating groove, and the centrifugal part abuts against the first limiting layer.

In this embodiment, the first limiting layer may be laid on the inner wall of the accommodating groove, and may occupy a relatively large area. Therefore, the centrifugal part may have a relatively large contact area with the inner wall of the accommodating groove, so that stability can be enhanced when the centrifugal part rotates in the accommodating groove.

In an embodiment, the shaft cover assembly includes a lifting/lowering block and a shaft cover that are fixedly disposed relative to each other, the shaft cover is disposed on a side that is of the lifting/lowering block and that is away from the rotating shaft base, and the accommodating groove is disposed in the lifting/lowering block. Therefore, when the shaft cover assembly moves in the thickness direction of the rotating shaft base, the shaft cover is driven by the lifting/lowering block to move. The lifting/lowering block is used as a position for disposing the accommodating groove.

In an embodiment, the limiting member further includes a second limiting layer and a connecting part, the second limiting layer is disposed on an outer wall of the lifting/lowering block, the inner wall of the accommodating groove is opposite to the outer wall of the lifting/lowering block, and the first limiting layer and the second limiting layer are connected by using the connecting part.

In this embodiment, the first limiting layer and the second limiting layer are sandwiched between the inner wall of the accommodating groove and the outer wall of the lifting/lowering block, so that the first limiting layer can be prevented from detaching from the accommodating groove due to sliding friction when the centrifugal part rotates.

In an embodiment, the lifting/lowering block includes a bottom plate and a first side plate. The bottom plate and the first side plate enclose to form at least a portion of the accommodating groove. An inlet of the accommodating groove is opposite to the bottom plate, and a plane on which the first side plate is located extends along the axis of the rotating shaft. The first limiting layer is located on a surface that is of the first side plate and that faces an interior of the accommodating groove, and the second limiting layer is located on a surface that is of the first side plate and that is away from the interior of the accommodating groove. The connecting part is connected to the first limiting layer and the second limiting layer through the inlet of the accommodating groove.

In this embodiment, the first limiting layer and the second limiting layer are respectively clamped on two surfaces of the first side plate. The first limiting layer can abut against a side wall of the limiting member, to increase a contact area between the first limiting layer and the limiting member.

In an embodiment, a protruding structure protruding toward the interior of the accommodating groove is disposed at the first limiting layer, and the protruding structure abuts against the centrifugal part.

In this embodiment, the protruding structure may have specific elasticity, and therefore, a buffering effect can be achieved for a centrifugal post when the centrifugal post shakes.

In an embodiment, the protruding structure is disposed on a middle portion of the first limiting layer. Two ends of the first limiting layer respectively abut against the surface that is of the first side plate and that faces the accommodating groove.

In this embodiment, when the protruding structure is squeezed by the centrifugal post, force may be transferred to the first side plate by using two end parts of the first limiting layer.

In an embodiment, the protruding structure is located at one end that is of the first limiting layer and that is close to the bottom plate.

In this embodiment, the protruding structure is disposed at the end that is of the first limiting layer and that is close to the bottom plate, so that limitation on an end part of the limiting member can be enhanced, thereby avoiding collision between the limiting member and the bottom of the accommodating groove.

In an embodiment, the lifting/lowering block includes a second side plate and a third side plate. Planes on which the second side plate and the third side plate are located extend along the axis of the rotating shaft, and are respectively located at two opposite ends of the first side plate. The bottom plate, the first side plate, the second side plate, and the third side plate enclose to form at least a portion of the accommodating groove. The first side plate, the second side plate, and the third side plate enclose the outer wall of the lifting/lowering block to form a first limiting groove, and the second limiting layer is located in the first limiting groove.

In this embodiment, the first limiting groove is formed by using the bottom plate, the first side plate, the second side plate, and the third side plate. A structure is simple, and a position of the second limiting layer can be limited, to prevent the second limiting layer from detaching from the outer wall of the lifting/lowering block.

In an embodiment, the first side plate, the second side plate, and the third side plate enclose the inner wall of the accommodating groove to form a second limiting groove, and the first limiting layer is located in the second limiting groove.

In this embodiment, the second limiting groove is formed by using the bottom plate, the first side plate, the second side plate, and the third side plate. A structure is simple, and a position of the first limiting layer can be limited, to prevent the first limiting layer from detaching from the inner wall of the accommodating groove.

In an embodiment, the lifting/lowering block includes a bottom plate, a first side plate, and a fourth side plate. An inlet of the accommodating groove is opposite to the bottom plate. A plane on which the first side plate is located and a plane on which the fourth side plate is located extend along the axis of the rotating shaft. The fourth side plate is opposite to the first side plate. The bottom plate, the first side plate, and the fourth side plate enclose to form at least a portion of the accommodating groove. The first limiting layer is located on a surface that is of the bottom plate and that faces an interior of the accommodating groove, and the second limiting layer is located on a surface that is of the bottom plate and that is away from the interior of the accommodating groove. The connecting part is connected to the first limiting layer and the second limiting layer through an opening located between the first side plate and the fourth side plate.

In this embodiment, the first limiting layer and the second limiting layer are clamped on two sides of the bottom plate, and the second limiting layer is limited to a bottom wall of the accommodating groove, so that collision caused by the limiting member to the bottom wall of the accommodating groove can be reduced, and abnormal sound can be reduced.

In an embodiment, the first limiting layer, the connecting part, and the second limiting layer are formed integrally. Overall strength of the limiting member is enhanced.

In an embodiment, the first limiting layer, the connecting part, and the second limiting layer are metal sheets. Therefore, the limiting member has specific toughness and elasticity, and can implement a buffering effect for the centrifugal part, thereby avoiding damage to the centrifugal part that is caused by hard contact.

In an embodiment, the first limiting layer, the second limiting layer, and the connecting layer are formed on the lifting/lowering block through injection molding. An injection molding manner is simple in process and low in costs, and can effectively match a size of the lifting/lowering block.

In an embodiment, the inner wall of the accommodating groove includes a bottom wall and a side wall, the bottom wall of the accommodating groove is opposite to an inlet of the accommodating groove, and the side wall extends along the axis of the rotating shaft. The first limiting layer is disposed on the bottom wall of the accommodating groove.

In an embodiment, two limiting steps are disposed at an interval on the bottom wall of the accommodating groove, and the first limiting layer is sandwiched between the two limiting steps. Space between the two limiting steps may be used to limit the first limiting layer 572, to prevent the first limiting layer from detaching from the bottom wall of the accommodating groove.

In an embodiment, the inner wall of the accommodating groove includes a bottom wall and a side wall, the bottom wall of the accommodating groove is opposite to an inlet of the accommodating groove, the side wall extends along the axis of the rotating shaft, and the first limiting layer is disposed on the side wall.

In an embodiment, a third limiting groove is disposed on a surface that is of the first limiting layer and that faces an interior of the accommodating groove, and the third limiting groove extends in a direction in which the rotating shaft extends. A side wall of the centrifugal part may be embedded into the third limiting groove, to reduce a degree of shaking of the centrifugal post.

In an embodiment, the rotating shaft mechanism further includes a guide mechanism. The guide mechanism is disposed between the shaft cover assembly and the rotating shaft base. The guide mechanism is configured to constrain the shaft cover assembly to move in the thickness direction of the rotating shaft base. Therefore, when the centrifugal part rotates, the rotating shaft assembly can be prevented from shaking from side to side, and the rotating shaft assembly can be limited to move in a vertical direction.

In an embodiment, a first guide hole is disposed on the rotating shaft base in the thickness direction of the rotating shaft base, a second guide hole is disposed on the lifting/lowering block, the first guide hole and the second guide hole are coaxially disposed, and a guide post penetrates the first guide hole and the second guide hole.

In an embodiment, the centrifugal part includes a centrifugal post, and the centrifugal post is fixedly disposed at one end of the rotating shaft. An axis of the centrifugal post is parallel to the axis of the rotating shaft, and a width of the accommodating groove is greater than a diameter of the centrifugal post. A width direction of the accommodating groove is separately perpendicular to the axis of the rotating shaft and the thickness direction of the rotating shaft base, and the axis of the rotating shaft is perpendicular to the thickness direction of the rotating shaft base.

When the centrifugal post rotates around the axis of the rotating shaft, a maximum displacement difference of the centrifugal post in the thickness direction of the rotating shaft base is a first distance, a height of the accommodating groove in the thickness direction of the rotating shaft base is a second distance, and the first distance is greater than the second distance.

In an embodiment, the rotating shaft mechanism further includes a swing arm, and the swing arm is fixedly connected to the rotating shaft.

An embodiment of this application further provides a rotating shaft mechanism. A rotating shaft base includes a rotating shaft base, a shaft cover assembly, a rotating shaft, and a centrifugal post. The shaft cover assembly is disposed on a side of the rotating shaft base in a thickness direction of the rotating shaft base, and an accommodating groove is disposed in the shaft cover assembly. The rotating shaft is rotatably disposed on the rotating shaft base. An axis of the rotating shaft is perpendicular to the thickness direction of the rotating shaft base. The centrifugal post is fixedly disposed at one end of the rotating shaft. An axis of the centrifugal post is parallel to the axis of the rotating shaft, a width of the accommodating groove is greater than a diameter of the centrifugal post, and a width direction of the accommodating groove is separately perpendicular to the axis of the rotating shaft and the thickness direction of the rotating shaft base. When the centrifugal post rotates around the axis of the rotating shaft, a maximum displacement difference of the centrifugal post in the thickness direction of the rotating shaft base is a first distance, a height of the accommodating groove in the thickness direction of the rotating shaft base is a second distance, and the first distance is greater than the second distance. A limiting member is at least partially located in the accommodating groove, and the limiting member is configured to abut against the centrifugal post in rotation.

In this embodiment, the maximum displacement difference of the centrifugal post in the thickness direction of the rotating shaft base is the first distance, the height of the accommodating groove in the thickness direction of the rotating shaft base is the second distance, the first distance is greater than the second distance, and the width of the accommodating groove is greater than the diameter of the centrifugal post. Therefore, there is space for the centrifugal post to move from side to side during rotation, and in addition, the centrifugal post can come into contact with a side wall of the accommodating groove in the thickness direction of the rotating shaft base, so that the shaft cover assembly can be driven to move up and down. In a process in which the centrifugal part rotates and moves, the limiting member can fill at least a gap between the accommodating groove and a centrifugal part. When the centrifugal part rotates, the centrifugal part can limit rotation or displacement of the limiting member relative to an inner wall of the accommodating groove, thereby reducing abnormal sound.

An embodiment of this application further provides a foldable terminal device, including the rotating shaft mechanism in the foregoing embodiment.

### BRIEF DESCRIPTION OF DRAWINGS

FIG. 1 is a schematic diagram of a flattened foldable terminal device according to some embodiments of this application;
FIG. 2 is a schematic diagram of a foldable terminal device at a specific folding angle according to some embodiments of this application;
FIG. 3 is a schematic diagram of a foldable terminal device at a specific folding angle according to some embodiments of this application;
FIG. 4 is a side view of a foldable terminal device in a folded state according to some embodiments of this application;
FIG. 5 is a schematic diagram of a flattened state of a rotating shaft mechanism according to some embodiments of this application;
FIG. 6 is a schematic diagram of a rotating shaft mechanism at a specific folding angle according to some embodiments of this application;
FIG. 7 is an exploded view of a rotating shaft mechanism according to some embodiments of this application;
FIG. 8 is a schematic diagram of a rotating shaft and a centrifugal part according to some embodiments of this application;
FIG. 9 is a schematic diagram of a cross-section A-A in FIG. 5 according to some embodiments of this application;
FIG. 10 is a schematic diagram of a cross-section B-B in FIG. 5 according to some embodiments of this application;
FIG. 10A is an enlarged view of a position M in an embodiment shown in FIG. 10;
FIG. 11 is a schematic diagram of a cross-section B-B in FIG. 6 according to some embodiments of this application;
FIG. 11A is an enlarged view of a position N in an embodiment shown in FIG. 11;
FIG. 12 is an exploded view including a lifting/lowering block and a limiting member according to some embodiments of this application;
FIG. 13 is a schematic diagram of an assembly mechanism in an embodiment of FIG. 12 on a cross-section B-B in FIG. 5;
FIG. 14 is a schematic diagram in which a lifting/lowering block fits a limiting member according to some embodiments of this application;
FIG. 15 is an exploded view of a lifting/lowering block and a limiting member according to some embodiments of this application;
FIG. 16 is a side sectional view of an assembly mechanism in an embodiment of FIG. 14;
FIG. 17 is an exploded view of a lifting/lowering block and a limiting member according to some embodiments of this application;
FIG. 18 is a schematic diagram of an assembly mechanism in an embodiment of FIG. 17 on a cross-section B-B in FIG. 5;
FIG. 19 is an exploded view including a lifting/lowering block and a limiting member according to some embodiments of this application;
FIG. 20 is a side sectional view of an assembly mechanism in an embodiment of FIG. 19;
FIG. 21 is a front sectional view of an assembly mechanism in an embodiment of FIG. 19;
FIG. 22 is a schematic diagram of a limiting member according to some embodiments of this application;
FIG. 23 is a schematic diagram of a limiting member according to some embodiments of this application;
FIG. 24 is an assembly diagram of a lifting/lowering block and a limiting member according to some embodiments of this application;
FIG. 25 is an assembly diagram including a lifting/lowering block and a limiting member according to some embodiments of this application; and
FIG. 26 is an exploded view of a lifting/lowering block and a limiting member in an embodiment of FIG. 25.

### Descriptions of reference numerals:

Foldable mobile phone 100;
Foldable screen 10;
Support apparatus 20;
First housing 21;
Second housing 22;
Rotating shaft mechanism 23;
Rotating shaft base 110;
Support plate 350;
First guide hole 351;
Second connecting sleeve 340;
Connecting plate 352;
Shaft cover assembly 120;
Lifting/lowering block 121;
Second guide hole 353;
Shaft cover 122;
Cylindrical protrusion 584;
Threaded groove 583;
Rotating shaft 320;
Swing arm 300;
First connecting sleeve 310;
Second cam 312;
Second convex part 313;
Second concave part 314;
Centrifugal part 330;
Limiting segment 322;
Flat position 324;
Damping structure 400;
Elastic member 410;
First cam 420;
First convex part 421;
First concave part 422;
Accommodating groove 500;
Inlet 501;
Bottom plate 550;
First side plate 510;
Limiting port 511;
Limiting step 512;
Second side plate 520;
Third side plate 530;
Fourth side plate 540;
Guide mechanism 560;
Guide post 561;
Limiting member 570;
First limiting layer 572;
Third limiting groove 573;
Protruding structure 574;
Second limiting layer 575;
Connecting part 576;
First limiting groove 584;
Second limiting groove 582.

### DESCRIPTION OF EMBODIMENTS

In embodiments of this application, the terms "first" and "second" are merely used for the purpose of description, and should not be understood as an indication or implication of relative importance or an implicit indication of a quantity of indicated technical features. Therefore, a feature defined by "first" or "second" may explicitly or implicitly include one or more features.

In the embodiments of this application, the term "drivable connection" means that movement of one of two connected components may be transmitted to the other component. A connection manner between the two components includes but is not limited to at least one of connection manners such as a rotatable connection, a slidable connection, a drivable connection through gear meshing, a drivable connection by using a sprocket, and a drivable connection by using a cam mechanism.

A foldable terminal device in the embodiments of this application may include an electronic device with a function of being foldable, such as a foldable mobile phone or a notebook computer. A foldable mobile phone is used as an example below to describe a specific structure of a foldable mechanism in the foldable terminal device.

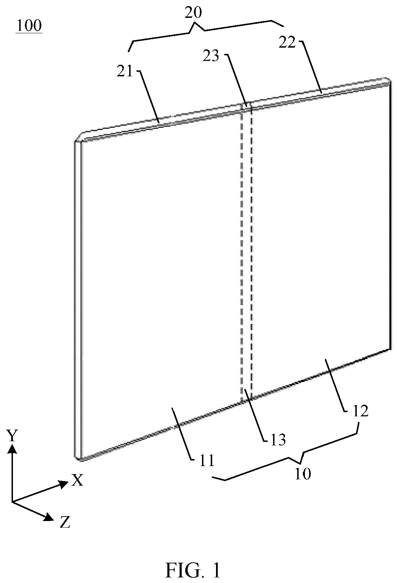

Refer to FIG. 1. FIG. 1 is a three-dimensional view of a foldable mobile phone 100 in an unfolded state according to some embodiments of this application. The foldable mobile phone 100 in the unfolded state is approximately in a shape of a rectangular flat plate. For ease of description in subsequent embodiments, an XYZ coordinate system is established for the foldable mobile phone 100 in the unfolded state. A length direction of the foldable mobile phone 100 is defined as an X-axis direction, a width direction of the foldable mobile phone 100 is defined as a Y-axis direction, and a thickness direction of the foldable mobile phone 100 is defined as a Z-axis direction. It may be understood that a coordinate system of the foldable device 100 may be flexibly set based on an actual requirement, and is not specifically limited herein. In some other embodiments, the foldable mobile phone 100 may be alternatively in a shape of a square flat plate, a shape of a circular flat plate, a shape of an elliptical flat plate, or the like.

The foldable mobile phone 100 includes a foldable screen 10 and a support apparatus 20.

The foldable screen 10 is configured to display information such as an image or a video. The foldable screen 10 may be an organic light-emitting diode (organic light-emitting diode, OLED) screen, a micro organic light-emitting diode (micro organic light-emitting diode) screen, a quantum dot light emitting diode (quantum dot light emitting diodes, QLED) screen, a liquid crystal display (liquid crystal display, LCD), or the like.

The foldable screen 10 has a display region used to display image information, and the display region of the foldable screen 10 is exposed, to present information such as an image or a video to a user. The foldable screen 10 includes a first display region 11, a second display region 12, and a third display region 13. The third display region 13 is connected between the first display region 11 and the second display region 12. In the foldable mobile phone 100 shown in FIG. 1, when the foldable screen 10 is in the unfolded state, the first display region 11, the third display region 13, and the second display region 12 are arranged in sequence in the X-axis direction. In this way, the foldable mobile phone 100 is horizontally folded. In some other embodiments, when the foldable screen 10 is in the unfolded state, the first display region 11, the third display region 13, and the second display region 12 may be alternatively arranged in sequence in the Y-axis direction. In this way, the foldable mobile phone 100 is vertically folded. When the foldable screen 10 is in the unfolded state, large-screen display can be implemented, to provide richer information for the user and bring better use experience to the user.

At least the third display region 13 of the foldable screen 10 is in a structure of a flexible screen. In this way, the third display region 13 may be bent and deformed under external force, so that the foldable screen 10 is folded from the unfolded state shown in FIG. 1 to a folded state. The first display region 11 and the second display region 12 of the foldable screen 10 each may be in the structure of a flexible screen, or may be in a structure of a hard screen, or may be partially in the structure of a flexible screen and partially in the structure of a hard screen. This is not specifically limited herein.

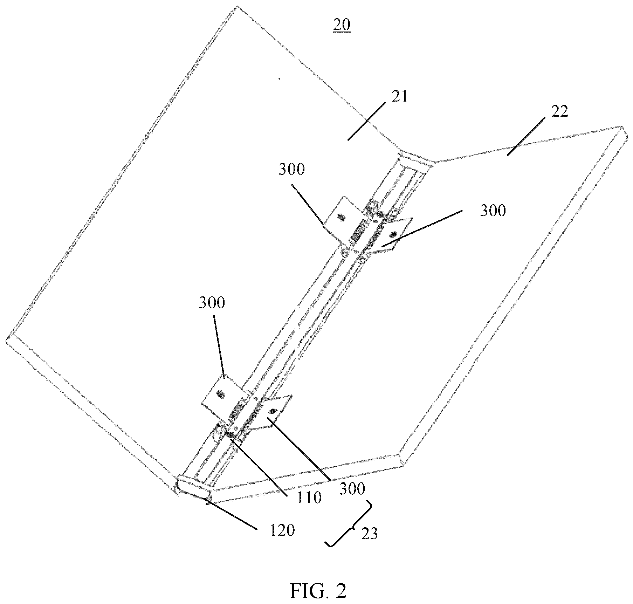

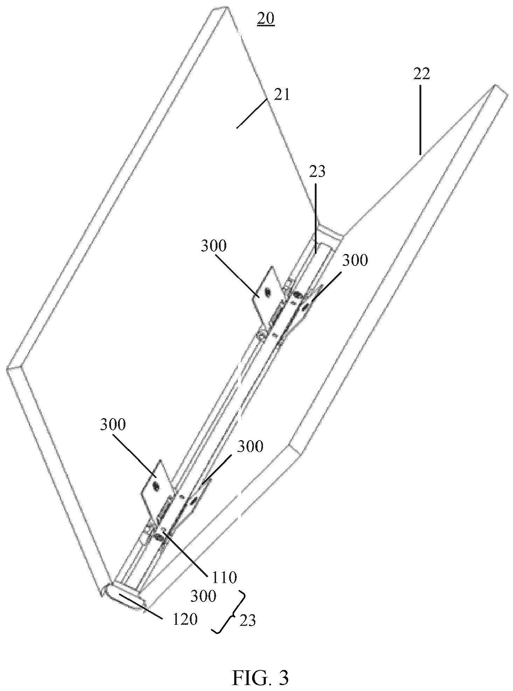

The support apparatus 20 is configured to bear the foldable screen 10. FIG. 2 and FIG. 3 are respectively schematic diagrams of the support apparatus 20 at different folding angles. The support apparatus 20 includes a first housing 21, a second housing 22, and a rotating shaft mechanism 23. The first housing 21 bears the first display region 11, and the second housing 22 bears the second display region 12. The rotating shaft mechanism 23 is connected between the first housing 21 and the second housing 22, and bears the third display region 13. The rotating shaft mechanism 23 is configured to implement switching of an angle between the second housing 22 and the first housing 21, to support switching of the foldable screen 10 between the unfolded state and the folded state. It may be understood that there may be a plurality of groups of rotating shaft mechanisms 23. The plurality of groups of rotating shaft mechanisms 23 may be connected between the first housing 21 and the second housing 22.

In the foregoing embodiment, optionally, the first housing 21 and the second housing 22 may each include a middle frame (not shown in the figure) and a back cover (not shown in the figure) that are connected to each other. An accommodating cavity is formed between the middle frame and the back cover, and the accommodating cavity is used to accommodate electronic components such as a mainboard, a camera module, and a battery. On this basis, the first housing 21 and the second housing 22 may be connected to the rotating shaft mechanism 23 by using the middle frame, or may be connected to the rotating shaft mechanism 23 by using the back cover.

The rotating shaft mechanism 23 may include a rotating shaft base 110 and a shaft cover assembly 120. It may be understood that there may be a plurality of rotating shaft mechanisms 23 in one foldable mobile phone 100. The plurality of rotating shaft mechanisms 23 may share one shaft cover assembly 120. Structures of the plurality of rotating shaft mechanisms 23 may be the same. One rotating shaft mechanism 23 is described below.

The rotating shaft base 110 may be configured to support the third display region 13 of the foldable screen 10. The first housing 21 and the second housing 22 may rotate around the rotating shaft base 110. There are a front surface and a back surface that are opposite to each other in a thickness direction (the Z direction shown in FIG. 1) of the rotating shaft base 110. The front surface may be used to bear the foldable screen 10.

The shaft cover assembly 120 may be used as a protection mechanism for the rotating shaft mechanism 23. The shaft cover assembly 120 may be configured to cover the rotating shaft base 110 in the rotating shaft mechanism 23 and a moving component (not shown in the figure) connected to the rotating shaft base 110. The shaft cover assembly 120 may be disposed on the back surface of the rotating shaft base 110.

In addition to the rotating shaft base 110 and the shaft cover assembly 120, the rotating shaft mechanism 23 may further include a swing arm 300. One swing arm 300 may be disposed at each of two ends of each rotating shaft base 110. Two swing arms 300 may rotate relative to the rotating shaft base 110. In other words, the two swing arms 300 may rotate by using the rotating shaft base 110 as an axis. The first housing 21 and the second housing 22 may be respectively fastened to the two swing arms 300. A manner of respectively fastening the two swing arms 300 to the first housing 21 and the second housing 22 is not limited, provided that the first housing 21 can be fastened relative to the swing arm 300. The swing arm 300 and the first housing 21 may be fastened by using a screw. Therefore, the first housing 21 and the second housing 22 can rotate relative to the rotating shaft base 110, so that the foldable mobile phone 100 moves between the unfolded state and the folded state. It may be understood that, in some embodiments, the rotating shaft mechanism 23 may alternatively not need the swing arm 300. The first housing 21 and the second housing 22 are directly rotatably disposed on the rotating shaft base 110.

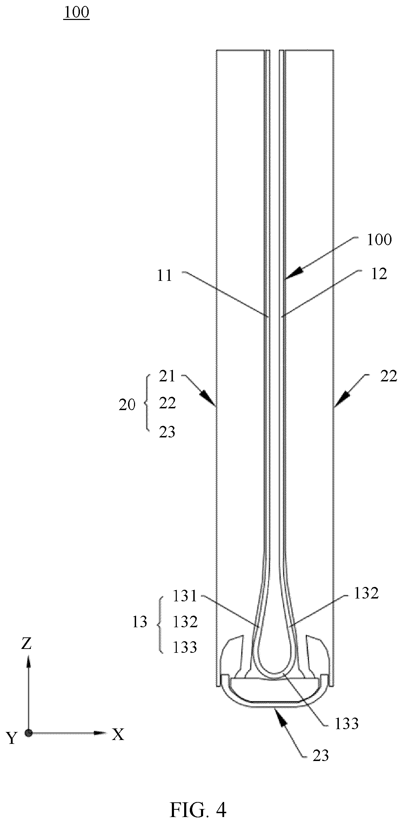

Continue to refer to FIG. 4. When the foldable screen 10 is in the folded state, the third display region 13 is folded into a water drop form. In this form, the third display region 13 includes an arc segment 133, a first transition segment 131, and a second transition segment 132. The first transition segment 131 is connected between the arc segment 133 and the first display region 11. The second transition segment 132 is connected between the arc segment 133 and the second display region 12. A distance between an end that is of the first transition segment 131 and that is connected to the first display region 11 and an end that is of the second transition segment 132 and that is connected to the second display region 12 is n, a distance between an end that is of the first transition segment 131 and that is connected to the arc segment 133 and an end that is of the second transition segment 132 and that is connected to the arc segment 133 is m, and n is greater than m. It may be understood that, when the foldable terminal device is in the folded state, the third display region 13 of the foldable screen 10 may be alternatively folded into another shape based on an actual requirement. This is not limited in this application.

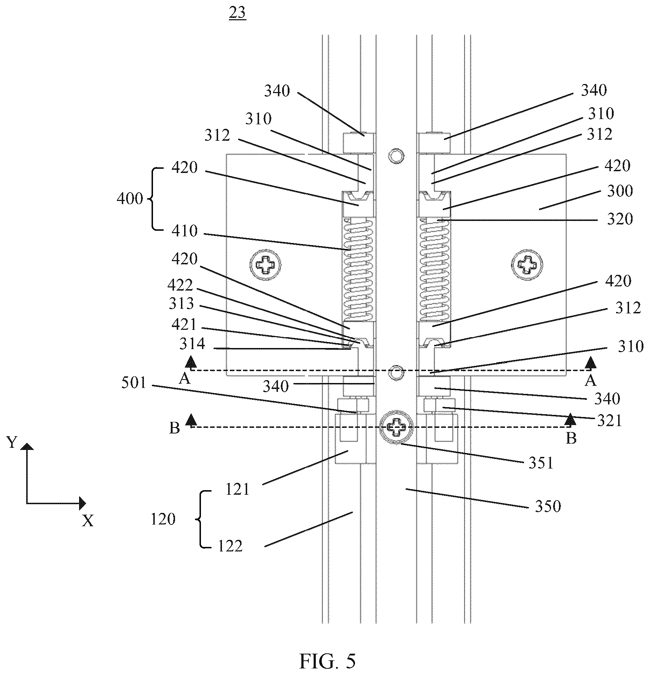

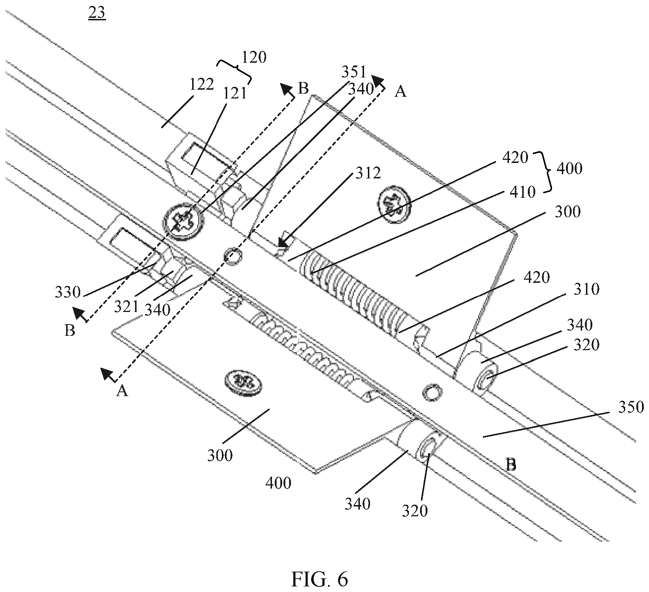

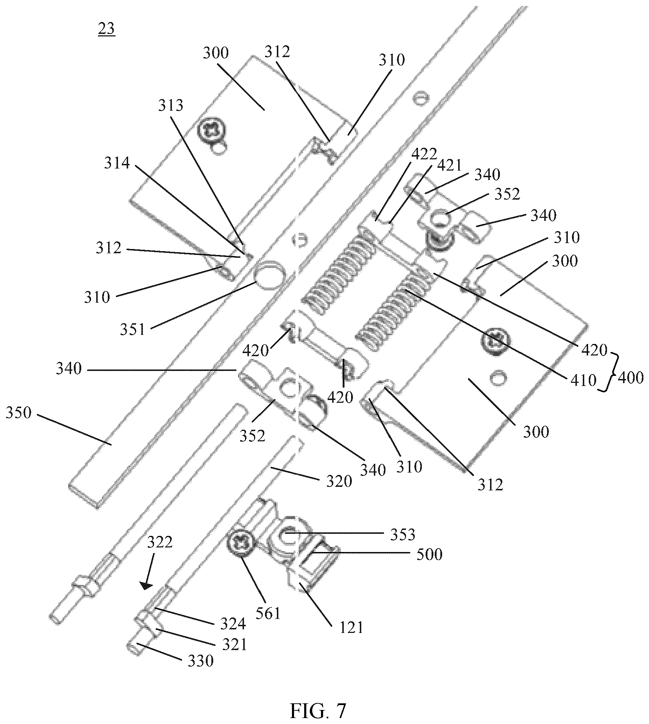

Refer to FIG. 5, FIG. 6, and FIG. 7. FIG. 5 is a schematic diagram of an unfolded state of the rotating shaft mechanism 23. FIG. 6 is a schematic diagram of a specific angle in a process in which the rotating shaft mechanism 23 switches from the unfolded state to the folded state. FIG. 7 is an exploded view of the rotating shaft mechanism 23 shown in FIG. 5 and FIG. 6.

At one end of each swing arm 300, there may be two first connecting sleeves 310. The two first connecting sleeves 310 may be coaxially disposed at an interval. The first connecting sleeve 310 and the swing arm 300 may be fixedly disposed relative to each other. In some embodiments, the first connecting sleeve 310 may be fastened to the swing arm 300 in a welding or bonding manner. In another embodiment, the first connecting sleeve 310 and the swing arm 300 may be alternatively formed integrally.

The rotating shaft base 110 (as shown in FIG. 3) may include a support plate 350 and a second connecting sleeve 340. The support plate 350 may be configured to support the third display region 13 (as shown in FIG. 1) of the foldable screen 10 (as shown in FIG. 1). Every two second connecting sleeves 340 may be connected by using one connecting plate 352. One second connecting sleeve 340 may be fixedly disposed at each of two ends of each connecting plate 352. In other words, two second connecting sleeves 340 and one connecting plate 352 may form one connecting sleeve assembly. Specifically, there may be two connecting sleeve assemblies. In some embodiments, the second connecting sleeve 340 may be fastened to the connecting plate 352 in a welding or bonding manner.

A width of the connecting plate 352 may be slightly greater than a width of the support plate 350, and the support plate 350 may be bridged across a surface of the connecting plate 352. In other words, the connecting plate 352 and the support plate 350 may be stacked. In this case, second connecting sleeves 340 at both ends of the connecting plate 352 are also located on both sides of the support plate 350. The two second connecting sleeves 340 may be symmetrically fastened on both sides of the support plate 350. The connecting plate 352 and the support plate 350 may be fixedly connected relative to each other. The connecting plate 352 and the support plate 350 may be fixedly connected by using a bolt. In some embodiments, the connecting plate 352 and the support plate 350 may be alternatively welded, riveted, or bonded. In some embodiments, the connecting plate 352 and the support plate 350 may be alternatively formed integrally.

In some embodiments, the second connecting sleeve 340 may be alternatively directly fastened to two opposite sides of the support plate 350. Optionally, the second connecting sleeve 340 and the support plate 350 may be formed integrally. The second connecting sleeve 340 may be alternatively fastened to the support plate 350 by using a mechanical structure or a welding process. In some optional embodiments, the second connecting sleeve 340 may be fastened to the support plate 350 by a screw.

In addition to the rotating shaft base 110 (as shown in FIG. 3), the shaft cover assembly 120, and the swing arm 300 described in the foregoing embodiment, the rotating shaft mechanism 23 may further include two rotating shafts 320. The rotating shaft 320 may extend in the Y direction. Each rotating shaft 320 may pass through two first connecting sleeves 310 and two second connecting sleeves 340. The two first connecting sleeves 310 may be located between the two second connecting sleeves 340.

One connecting plate 352 may be disposed at each of two ends of the rotating shaft mechanism 23 in the Y direction. A length direction of the connecting plate 352 may be consistent with the X direction. Second connecting sleeves 340 at both ends of each connecting plate 352 may separately pass through one rotating shaft 320. Two swing arms 300 are respectively fixedly disposed on one rotating shaft 320 relative to each other by using the first connecting sleeve 310, and the rotating shaft 320 can rotate relative to the second connecting sleeve 340. Therefore, the two swing arms 300 can be rotatably disposed relative to the rotating shaft base 110. For each rotating shaft 320, the two second connecting sleeves 340 are disposed at two ends of the rotating shaft 320, and may serve to limit the two first connecting sleeves 310, to prevent the swing arm 300 from slipping off the rotating shaft 320.

The rotating shaft 320 may be fixedly connected to the first connecting sleeve 310. In other words, the rotating shaft 320 and the first connecting sleeve 310 do not rotate relative to each other. When rotating, the first connecting sleeve 310 can drive the rotating shaft 320 to rotate. The rotating shaft 320 may be rotatably connected to the second connecting sleeve 340. In other words, the rotating shaft 320 may rotate freely in the second connecting sleeve 340. Rotation herein means that the rotating shaft 320 can self-rotate around an axis of the rotating shaft 320.

When rotating around the rotating shaft base 110 (as shown in FIG. 3), the swing arm 300 can drive the first connecting sleeve 310 to rotate. The first connecting sleeve 310 is fixedly connected to the rotating shaft 320 through rotation, and therefore, the first connecting sleeve 310 can drive the rotating shaft 320 to self-rotate. The rotating shaft 320 fits the second connecting sleeve 340 through rotation, and the second connecting sleeve 340 is fixedly disposed relative to the support plate 350. Therefore, the rotating shaft 320 can rotate relative to the support plate 350.

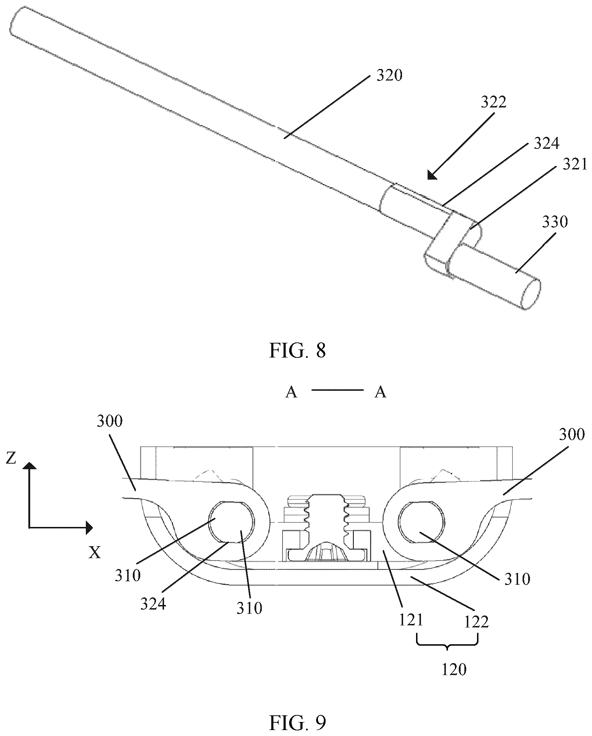

Refer to FIG. 7 and FIG. 8. The rotating shaft 320 may have a limiting segment 322, and a flat position 324 may be formed on a surface of the limiting segment 322. Through the flat position 324, the rotating shaft 320 can be prevented from rotating relative to the first connecting sleeve 310 in the first connecting sleeve 310, so that the rotating shaft 320 is fixedly disposed with the first connecting sleeve 310.

Refer to FIG. 9. FIG. 9 is a cross-sectional view at a position A-A in FIG. 5 and FIG. 6. A shape of an inner wall of the first connecting sleeve 310 may match a shape of a surface of the limiting segment 322. In other words, a contour of a cross-section of the limiting segment 322 is basically the same as a shape of a cross-section that is of the first connecting sleeve 310 and that correspondingly accommodates the limiting segment 322. Another portion of the rotating shaft 320 except a segment of the flat position 324 may be cylindrical. When swinging, the swing arm 300 drives the first connecting sleeve 310. The first connecting sleeve 310 drives, by using the flat position 324, the rotating shaft 320 to self-rotate. Therefore, the swing arm 300 can swing relative to the rotating shaft base 110.

In some embodiments, the rotating shaft 320 may be in interference fit with the first connecting sleeve 310, so that the rotating shaft 320 and the first connecting sleeve 310 are fastened to each other. The swing arm 300 may be fastened to the rotating shaft 320 in a welding manner. The swing arm 300 may be alternatively fastened to the rotating shaft 320 in a mechanical connection manner such as riveting or a screw connection.

Continue to refer to FIG. 5, FIG. 6, and FIG. 7. The rotating shaft mechanism 23 further includes a damping mechanism 400. The damping mechanism 400 may include an elastic member 410 and a first cam 420. Specifically, one elastic member 410 and two first cams 420 are configured for each rotating shaft 320. The elastic member 410 may be disposed between the two first cams 420. For each rotating shaft 320, the first connecting sleeve 310, the first cam 420, the elastic member 410, the first cam 420, and the first connecting sleeve 310 are arranged in sequence in an axis direction of the rotating shaft 320. A second cam 312 is disposed at an end that is of each first connecting sleeve 310 and that faces the first cam 420. The first cam 420 may have a first convex part 421 and a first concave part 422. The second cam 312 has a second convex part 313 and a second concave part 314, separately. For example, for the first cam 420 and the second cam 312 that are adjacent, when the swing arm 300 is being switched from an unfolded state to a folded state, the second convex part 313 of the second cam 312 gradually slides from the first concave part 422 of the first cam 420 to the first convex part 421 of the first cam 420. Therefore, the second convex part 313 of the second cam 312 gradually abuts against the first convex part 421 of the first cam 420, and therefore, the second cam 312 squeezes the elastic member 410 by using the first cam 420. When the swing arm 300 is being switched from the unfolded state to the folded state, resistance caused by the elastic member 410 is experienced, so that hand feel is improved. There may be a pair of first cam 420 and second cam 312 at each of two ends of the rotating shaft 320. A fitting manner of the pair of first cam 420 and second cam 312 is the same as that described in the foregoing embodiment. Therefore, the elastic member 410 may be separately squeezed from both ends.

It may be understood that when the swing arm 300 is being switched from the folded state to the unfolded state, a motion manner of the elastic member 410 is opposite to this, and therefore, the swing arm 300 can be assisted to be unfolded. For example, the elastic member 410 may be a spring. The spring may be sleeved on the rotating shaft 320.

Still refer to FIG. 7 and FIG. 8. A centrifugal part 330 may be disposed at an end part of the rotating shaft 320. The centrifugal part 330 is centrifugal relative to the axis of the rotating shaft 320. In other words, when the swing arm 300 drives the rotating shaft 320 to self-rotate, the centrifugal part 330 rotates around the axis of the rotating shaft 320. It may be understood that, when the rotating shaft 320 rotates, the centrifugal part 330 may have a displacement component in the thickness direction of the rotating shaft base 110. For example, in a process in which the rotating shaft 320 rotates by one circle, the centrifugal part 330 has a highest point and a lowest point in the thickness direction of the rotating shaft base 110. A distance between the highest point and the lowest point may be a maximum displacement difference of the centrifugal part 330 in the thickness direction of the rotating shaft base 110.

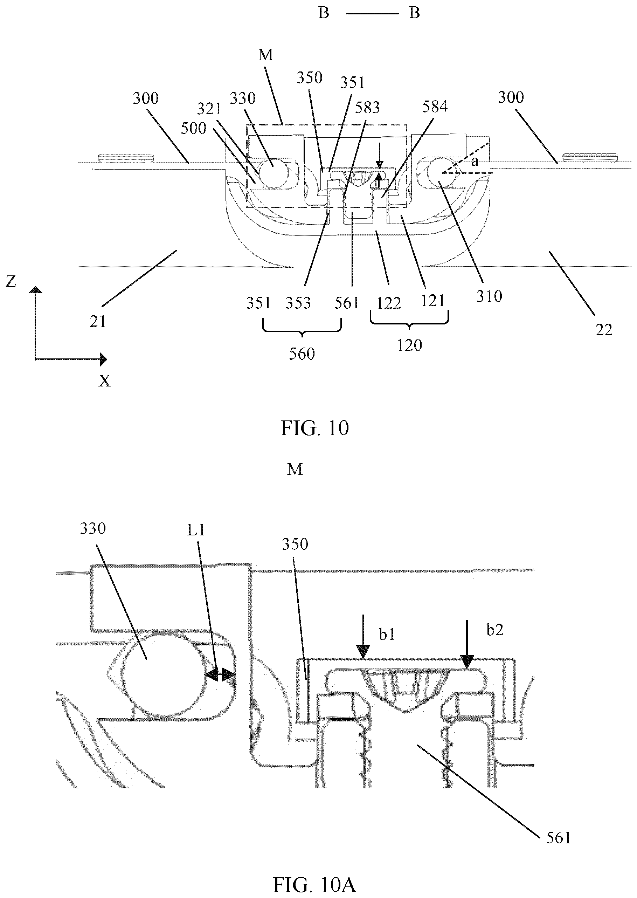

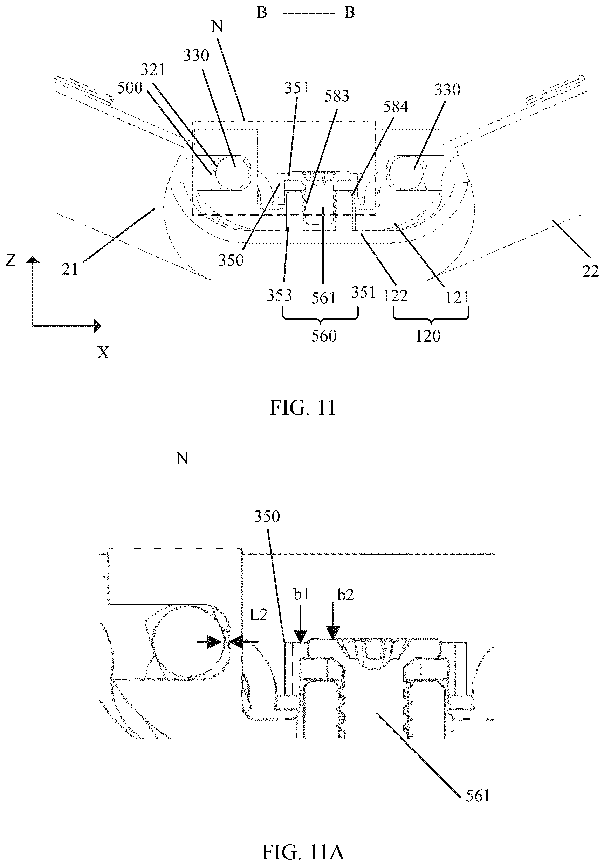

Still refer to FIG. 5, FIG. 6, FIG. 7 (a shaft cover 122 is not shown), FIG. 10, and FIG. 11. FIG. 10 and FIG. 11 are cross-sectional views at a position B-B in FIG. 5 and FIG. 6. The shaft cover assembly 120 may include a shaft cover 122 and a lifting/lowering block 121. The shaft cover 122 and the lifting/lowering block 121 may be fixedly disposed relative to each other. The lifting/lowering block 121 may be located on the back surface of the rotating shaft base 110 (as shown in FIG. 3). The shaft cover 122 is disposed on a side that is of the lifting/lowering block 121 and that is away from the rotating shaft base 110. In other words, the lifting/lowering block 121 is located between the rotating shaft base 110 and the shaft cover 122. A form of fastening the shaft cover 122 and the lifting/lowering block 121 is not limited. A form of welding, riveting, or the like may be used between the shaft cover 122 and the lifting/lowering block 121. The shaft cover 122 and the lifting/lowering block 121 may be alternatively fastened by using a common mechanical connection, such as clamping or a threaded connection. An accommodating groove 500 may be disposed on a side wall of the lifting/lowering block 121. The centrifugal part 330 may be inserted into the accommodating groove 500 in an axial direction of the rotating shaft 320.

The centrifugal part 330 may be a centrifugal post. Refer to FIG. 8. The centrifugal post may be connected to the rotating shaft 320 by using a connecting arm 321. The connecting arm 321 may be separately perpendicular to the centrifugal post and the rotating shaft 320. The centrifugal post may be rotatably disposed in the accommodating groove 500. The centrifugal part 330 is in clearance fit with the accommodating groove 500; in other words, a cross-sectional area of the centrifugal part 330 may be less than a cross-sectional area of the accommodating groove 500. There is space for the centrifugal part 330 to rotate and move in the accommodating groove 500. A diameter of the centrifugal post may be less than a width of the accommodating groove 500 in the X direction. A height of an inner wall of the accommodating groove 500 in the thickness direction of the rotating shaft base 110 is less than a maximum displacement difference of the centrifugal part 330 in the thickness direction of the rotating shaft base 110 in one rotation period. Therefore, in the thickness direction of the rotating shaft base 110, when rotating, the centrifugal part 330 can drive the shaft cover assembly 120 to move in the thickness direction of the rotating shaft base 110.

Continue to refer to FIG. 10 and FIG. 11. The rotating shaft mechanism 23 (as shown in FIG. 3) may further include a guide mechanism 560. The guide mechanism 560 may be disposed between the shaft cover assembly 120 and the rotating shaft base 110. The guide mechanism 560 may include a guide post 561. A second guide hole 353 is disposed on the lifting/lowering block 121. The rotating shaft base 110 has a first guide hole 351 that is disposed in the thickness direction of the rotating shaft base 110. Specifically, the first guide hole 351 may be disposed on the support plate 350. The first guide hole 351 and the second guide hole 353 are disposed coaxially, and the guide post 561 penetrates the first guide hole 351 and the second guide hole 353. The guide post 561 passes through the first guide hole 351 and the second guide hole 353.

The guide post 561 may be a screw. A threaded groove 583 may be disposed on a surface that is of the shaft cover 122 and that faces the rotating shaft base. The screw may pass through the first guide hole 351 disposed on the support plate 350 and the second guide hole 353 disposed on the lifting/lowering block 381, and then is inserted into the threaded groove 583 to fit the threaded groove 583. In other words, the screw is relatively fastened to the shaft cover 122 and the lifting/lowering block 121 by using the threaded groove 583. A diameter of the first guide hole 351 may be slightly greater than a diameter of the screw. In other words, the first guide hole 351 may be in clearance fit with the screw, so that the screw can move in an axial direction of the first guide hole 351. The first guide hole 351 may have a constraining effect on movement of the screw. The first guide hole 351 may limit the screw to move in the thickness direction of the rotating shaft base, to prevent the screw from swinging in the X direction.

Further, the threaded groove 583 may be formed in a cylindrical protrusion 584 on a surface of the shaft cover 122. A diameter of the cylindrical protrusion 584 may be less than a diameter of the second guide hole 353. Therefore, the cylindrical protrusion 584 may pass through the second guide hole 353 to be close to the first guide hole 351. The first guide hole 351 can also have a limiting effect on movement of the cylindrical protrusion 584, to prevent the first guide hole 351 from swinging in the X direction.

A process in which the centrifugal post drives the shaft cover assembly 120 to move is described below.

As shown in FIG. 10 and FIG. 11, when the rotating shaft mechanism 23 (as shown in FIG. 3) is being switched from the unfolded state to the folded state, the two swing arms 300 rotate toward each other at an angle of view in FIG. 11. It may be understood that, when rotating, the centrifugal post has both a component moving in the X direction and a component moving in the Z direction.

As described in the foregoing embodiment, in the Z direction, a height of the inner wall of the accommodating groove 500 in the thickness direction of the rotating shaft base 110 is less than the maximum displacement difference of the centrifugal part 330 in the thickness direction of the rotating shaft base 110 (as shown in FIG. 3) in one rotation period. Therefore, in the thickness direction of the rotating shaft base 110, when rotating, the centrifugal part 330 is in contact with the inner wall of the accommodating groove 500 in the Z direction, so that the shaft cover assembly 120 can be driven to move in the thickness direction of the rotating shaft base 110.

As shown in FIG. 10A and FIG. 11A, FIG. 10A is an enlarged view of FIG. 10 at a position M, and FIG. 11A is an enlarged view of FIG. 11 at a position N. A relative height of a top part b2 (a surface that is of the guide post 561 and that is away from the shaft cover 122 in the Z direction) of the guide post 561 and a relative height of a top part b1 (a surface that is of the support plate 350 and that is away from the shaft cover 122 in the Z direction) of the support plate 350 in a pose in FIG. 10 are different from those in a pose in FIG. 11. When the swing arm 300 is in the unfolded state, the top part b2 of the guide post 561 is lower than the top part b1 of the support plate 350. When the swing arm 300 is folded to a specific angle, the top part b2 of the guide post 561 exceeds the top part b1 of the support plate 350. In other words, when the swing arm 300 is being switched from the unfolded state to the folded state, the shaft cover assembly 120 may move in a direction approaching the rotating shaft base 110; and when the swing arm 300 is being switched from the folded state to the unfolded state, the shaft cover assembly 120 may move in a direction away from the rotating shaft base 110.

In this case, the shaft cover assembly 120 is closer to the rotating shaft base 110 when the swing arm 300 is in the folded state. The shaft cover assembly 120 approaches the rotating shaft base 110 when being folded, so that a gap between the shaft cover assembly 120 and the rotating shaft base 110 can be reduced, and a risk that the rotating shaft base 110 and a component connected to the rotating shaft base 110 are exposed can be avoided to some extent.

It may be understood that, through changing of a centrifugal angle or a shape of the centrifugal post, a moving direction of the shaft cover assembly 120 relative to the rotating shaft base 110 can be changed. Continue to refer to FIG. 10. When the rotating shaft mechanism 23 (as shown in FIG. 3) is in a horizontally unfolded state, and when the swing arm 300 is in a horizontally unfolded state, an included angle between the connecting arm 321 and a horizontal direction (the X direction) is a. The connecting arm 321 may be enabled to rotate by 2×(90°-a) on the basis of the angle a in an anti-clockwise direction shown in the figure, and a position of the centrifugal post at this angle is used as an initial position from which the swing arm 300 is switched from the unfolded state to the folded state. In this case, when the swing arm 300 is being switched from the unfolded state to the folded state, the shaft cover assembly 120 may move in a direction away from the rotating shaft base 110. When the swing arm 300 is being switched from the folded state to the unfolded state, the shaft cover assembly 120 may move in a direction approaching the rotating shaft base 110, and may provide, in the folded state, larger space between the rotating shaft base 110 and the shaft cover assembly 120.

It can be learned from the foregoing embodiments that because the shaft cover assembly 120 is constrained in the Z direction by the guide mechanism 560, that is, the shaft cover assembly 120 cannot move in the X direction with the centrifugal post when the centrifugal post rotates, the centrifugal post moves in the X direction relative to the accommodating groove 500.

Continue to refer to FIG. 10A and FIG. 11A. In the X direction, there is a first distance L1 between the centrifugal post and the inner wall of the accommodating groove 500. When the swing arm 300 is being switched from the unfolded state to the folded state, the centrifugal post is driven by the swing arm 300 to move to the right in the X direction to approach the inner wall of the accommodating groove 500. In this case, a distance between the centrifugal post and the inner wall of the accommodating groove 500 may be a second distance L2, and the second distance L2 may be less than the first distance L1. In this process, the centrifugal post rolls in the accommodating groove 500. Due to a gap between the centrifugal post and the inner wall of the accommodating groove 500, the centrifugal post may collide with the inner wall of the accommodating groove 500 due to shaking in a rolling process, and consequently, abnormal sound is caused.

Inventors find through further researches that sliding friction is caused between the centrifugal post and the inner wall of the accommodating groove 500 during rotation of the centrifugal post. If the gap between the centrifugal part 330 and the inner wall of the accommodating groove 500 is not well controlled, abnormal sound may be caused in a process of reciprocating motion of the centrifugal part 330 due to collision with the inner wall of the accommodating groove 500. If the gap between the centrifugal part 330 and the inner wall of the accommodating groove 500 is strictly controlled, an extremely high requirement is imposed on processing precision of the accommodating groove 500 and the centrifugal part 330, and this increases production costs. Therefore, a solution for reducing abnormal sound of the rotating shaft mechanism 23 at low costs is proposed.

The rotating shaft mechanism 23 in this embodiment of this application may include a limiting member. At least a portion of the limiting member may be located in the accommodating groove 500. Alternatively, the limiting member may be entirely disposed in the accommodating groove 500. The limiting member may be configured to adjust the gap between the centrifugal part 330 and the inner wall of the accommodating groove 500, so that shaking of the limiting member in the accommodating groove 500 can be limited, and hard friction between the centrifugal part 330 and the inner wall of the accommodating groove 500 can be reduced, thereby reducing abnormal sound. If the gap between the centrifugal part 330 and the inner wall of the accommodating groove 500 is reduced by using the limiting member, a requirement on processing precision of the accommodating groove 500 and the centrifugal part 330 can also be reduced, and costs are effectively reduced.

Hardness of a material of the limiting member may be less than hardness of the inner wall of the accommodating groove 500 and the centrifugal part 330, and the limiting member may achieve a buffering effect between the accommodating groove 500 and the centrifugal part 330. In some embodiments, the limiting member may be a block structure or a layered structure. A shape of the limiting member may alternatively match a shape of the inner wall of the accommodating groove 500, or the shape of the limiting member may match a shape of the centrifugal post.

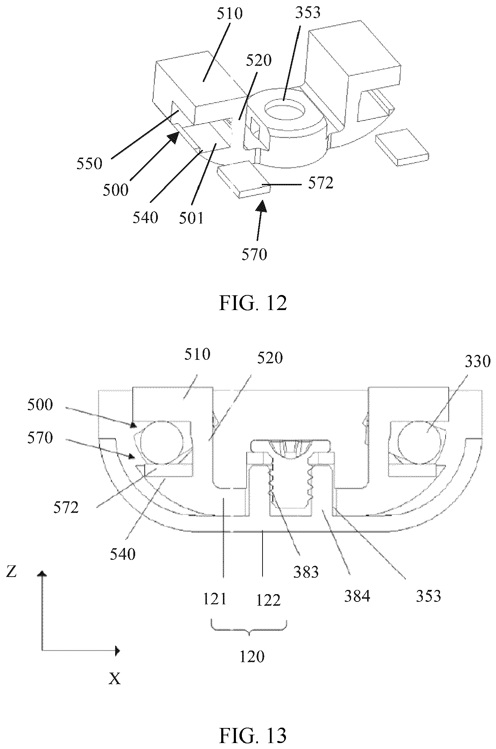

Refer to FIG. 12 and FIG. 13. A limiting member 570 includes a first limiting layer 572. FIG. 12 is an exploded view in which the lifting/lowering block 121 fits the first limiting layer 572. FIG. 13 is a side cross-sectional view in which the lifting/lowering block 121 fits the first limiting layer 572 in FIG. 12. The accommodating groove 500 may include a bottom plate 550, a first side plate 510, a second side plate 520, and a fourth side plate 540. The bottom plate 550, the first side plate 510, the second side plate 520, and the fourth side plate 540 may enclose to form the accommodating groove 500. The first side plate 510, the second side plate 520, and the fourth side plate 540 respectively extend along the axis of the rotating shaft 320 (as shown in FIG. 7). End parts of the first side plate 510, the second side plate 520, and the fourth side plate 540 separately abut against the bottom plate 550. The bottom plate 550 may be perpendicular to the axis of the rotating shaft 320. A plane on which the first side plate 510 is located may be perpendicular to a plane on which the second side plate 520 is located. The fourth side plate 540 may be disposed close to the shaft cover 122. The fourth side plate 540 may be parallel to the first side plate 510. The bottom plate 550, the first side plate 510, the second side plate 520, and the fourth side plate 540 may be formed by splicing mechanical structures, or may be formed integrally.

There may be an inlet 501 at ends that are of the first side plate 510, the second side plate 520, and the fourth side plate 540 and that are away from the bottom plate 550. In other words, the bottom plate 550 may be opposite to the inlet 501. The centrifugal part 330 may enter the accommodating groove 500 through the inlet 501. Surfaces that are of the first side plate 510, the second side plate 520, and the fourth side plate 540 and that face an interior of the accommodating groove 500 may constitute a side wall of the accommodating groove 500. A surface that is of the bottom plate 550 and that faces the interior of the accommodating groove 500 forms a bottom wall of the accommodating groove 500. That the bottom plate 550 is opposite to the inlet 501 may be understood as that the bottom wall of the accommodating groove 500 is opposite to the inlet 501. The bottom wall of the accommodating groove 500 and the side wall of the accommodating groove 500 may constitute the inner wall of the accommodating groove 500.

The first limiting layer 572 may be located on the side wall of the accommodating groove 500. Specifically, the first limiting layer 572 may be fastened on a surface that is of the fourth side plate 540 and that faces the interior of the accommodating groove 500. The fourth side plate 540 may be closer to the shaft cover 122 than the first side plate 510. The first limiting layer 572 may extend in a depth direction (the Y direction) of the accommodating groove 500. A side wall of the centrifugal post may be in contact with a surface of the first limiting layer 572. The first limiting layer 572 may be fastened to the side wall of the accommodating groove 500 in a bonding or welding manner. The first limiting layer 572 can fill the gap between the accommodating groove 500 and the centrifugal post in the Z direction, to reduce collision between the centrifugal post and the side wall of the accommodating groove 500 in the Z direction.

It may be understood that the first limiting layer 572 may be disposed at any position on the inner wall of the accommodating groove 500, provided that the first limiting layer 572 can be located between the centrifugal part 330 and the inner wall of the accommodating groove 500 to reduce abnormal sound. In some embodiments, the first limiting layer 572 may be in interference fit with the centrifugal post. The first limiting layer 572 may provide resistance for rotation of the centrifugal post. Therefore, a damping effect can be implemented, and hand feel of opening/closing during an operation of the user is improved. It may be understood that the first limiting layer 572 may be a plate-shape structure, and a thickness of the first limiting layer 572 may be set as required.

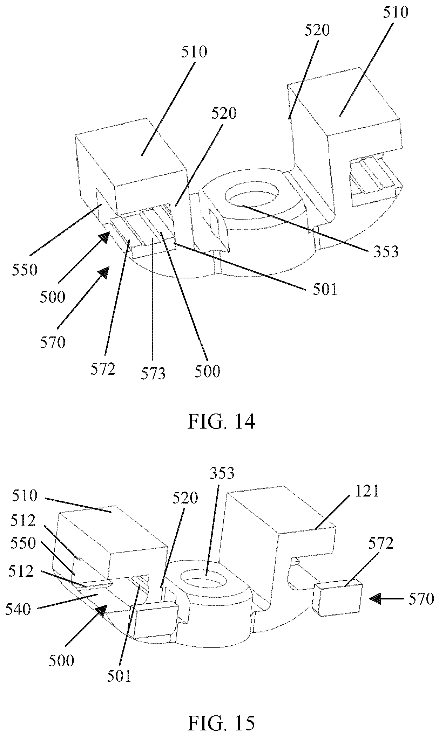

Refer to FIG. 14. Based on the embodiments of FIG. 12 and FIG. 13, a third limiting groove 573 may be formed on a surface that is of the first limiting layer 572 and that faces the inner wall of the accommodating groove 500. The third limiting groove 573 extends in a direction in which the rotating shaft 320 extends. In other words, the side wall of the centrifugal post may be embedded into the third limiting groove 573 to reduce a degree of shaking of the centrifugal post. In some embodiments, a material of the first limiting layer 572 may be a material with specific flexibility such as rubber or a metal sheet. The first limiting layer 572 may be fastened to the side wall of the accommodating groove 500 in a bonding or welding manner.

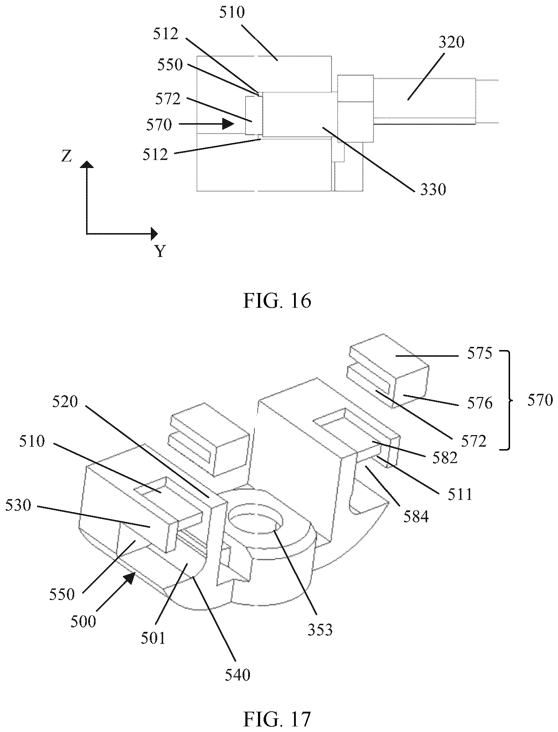

Refer to FIG. 15 and FIG. 16. FIG. 15 is an exploded view in which the lifting/lowering block 121 fits the first limiting layer 572. FIG. 16 is a side cross-sectional view in which the lifting/lowering block 121 fits the first limiting layer 572 in FIG. 15. A difference between this embodiment and the embodiments of FIG. 12 and FIG. 13 is that the first limiting layer 572 may be located on the bottom wall of the accommodating groove 500. In other words, the first limiting layer 572 may cover the bottom wall of the accommodating groove 500. An end part of the centrifugal post may abut against the bottom wall of the accommodating groove 500. Therefore, the first limiting layer 572 can prevent the centrifugal post from shaking in the axial direction of the rotating shaft 320. In addition, the end part of the centrifugal post may abut against the surface of the first limiting layer 572. When the end part of the centrifugal post abuts against the first limiting layer 572, the end part of the centrifugal post can be prevented from directly colliding with a bottom part of the accommodating groove 500 due to shaking, thereby reducing abnormal sound. When the end part of the centrifugal post abuts against the first limiting layer 572, a damping effect can also be achieved for rotation of the centrifugal post.

Based on the embodiments shown in FIG. 15 and FIG. 16, a limiting step 512 is disposed on the bottom wall of the accommodating groove 500. The limiting step 512 may extend in the X direction on a surface of the bottom plate 550. A quantity of limiting steps 512 is not limited. As shown in FIG. 15 and FIG. 16, when there are two limiting steps 512, the two limiting steps 512 may be respectively disposed on two opposite edges of the bottom wall of the accommodating groove 500, and respectively abut against the side wall of the accommodating groove 500. Space between the two limiting steps may be used to limit the first limiting layer 572 to prevent the first limiting layer 572 from detaching from the bottom wall of the accommodating groove 500.

In some embodiments, when there is one limiting step 512, the first limiting layer 572 is sandwiched between the limiting step 512 and the side wall of the accommodating groove 500. For example, the limiting step 512 may be located on an edge of the bottom wall of the accommodating groove 500. Space may be formed between the limiting step 512 and the side wall of the accommodating groove 500, and the first limiting layer 572 may be accommodated in the space, to prevent the first limiting layer 572 from shaking in the accommodating groove 500. The limiting step 512 may be formed integrally with the inner wall of the accommodating groove 500. The limiting step 512 may be alternatively fastened to the inner wall of the accommodating groove 500 as a separate part.

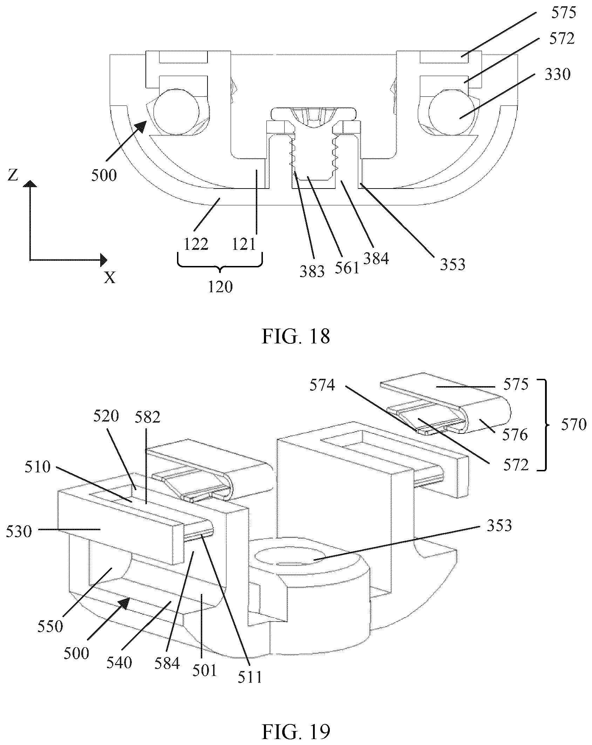

Refer to FIG. 17 and FIG. 18. FIG. 17 is an exploded view of the lifting/lowering block 121 and the limiting member 570 in an embodiment. FIG. 18 is a schematic cross-sectional view in which the lifting/lowering block 121 fits the limiting member 570 in FIG. 17.

In addition to the first limiting layer 572, the limiting member 570 may further include a second limiting layer 575 and a connecting part 576. The second limiting layer 575 may be located on an outer wall of the lifting/lowering block 121. The second limiting layer 575 may be fastened to the outer wall of the lifting/lowering block 121 in a bonding or embedding manner. The first limiting layer 572 may be located on the inner wall of the accommodating groove 500. The first limiting layer 572 may be connected to the second limiting layer 575 by using the connecting part 576. The connecting part 576 may connect, in a bent state, the first limiting layer 572 and the second limiting layer 575. Projections of the first limiting layer 572 and the second limiting layer 575 on the inner wall of the accommodating groove 500 may have an overlapping portion, or may have no overlapping portion. The second limiting layer 575 may play a binding role on the first limiting layer 572 to prevent the first limiting layer 572 from detaching from the inner wall of the accommodating groove 500. In other words, when the centrifugal post rotates, the first limiting layer 572 does not easily detach from the interior of the accommodating groove 500.

In some embodiments, the connecting part 576 may be a flexible material such as polyester, or may be a flexible metal material. The connecting part 576 may be a layered structure, or may be a columnar structure that can be bent. Both ends of the columnar structure may be respectively connected to the first limiting layer 572 and the second limiting layer 575. The connecting part 576 may be alternatively embedded into the outer wall of the lifting/lowering block 121, to prevent detachment of the connecting part 576.

The first limiting layer 572, the second limiting layer 575, and the connecting part 576 may be formed integrally. When the first limiting layer 572, the connecting part 576, and the second limiting layer 575 are flattened and laid on a plane, a flat plate structure is formed. The first limiting layer 572, the second limiting layer 575, and the connecting part 576 may be U-shaped after being molded. When the limiting member 570 fits the lifting/lowering block 121, the first limiting layer 572 and the second limiting layer 575 may be separately bonded between the inner wall of the accommodating groove 500 and the outer wall of the lifting/lowering block 121. It may be understood that the outer wall of the lifting/lowering block 121 and the outer wall of the accommodating groove 500 are a same surface.

The first limiting layer 572, the connecting part 576, and the second limiting layer 575 may be formed on the lifting/lowering block 121 in an injection molding manner. Materials of the first limiting layer 572, the connecting part 576, and the second limiting layer 575 may be rubber, for example, a polyester material such as rubber, or may be a polycarbonate (PC) material. In some embodiments, a protruding structure 574 may be alternatively fabricated by using a mold.

Continue to refer to FIG. 17 and FIG. 18. The accommodating groove 500 may further include a third side plate 530 in addition to the first side plate 510, the second side plate 520, and the fourth side plate 540. The plane on which the first side plate 510 is located may be perpendicular to the thickness direction of the rotating shaft base 110 (as shown in FIG. 3). The second side plate 520 and the third side plate 530 may be respectively located at two opposite ends of the first side plate 510. The plane on which the second side plate 520 is located and a plane on which the third side plate 530 is located may extend along the axis of the rotating shaft 320. In other words, the second side plate 520 and the third side plate 530 may be parallel to the axis of the rotating shaft 320. Further, the second side plate 520 and the third side plate 530 may be parallel to the Z direction. Two opposite ends of the first side plate 510 may respectively abut against two opposite surfaces of the second side plate 520 and the third side plate 530. On one side of the first side plate 510, that is, on a side that is of the limiting block 121 and that is away from the accommodating groove 500, the first side plate 510, the second side plate 520, and the third side plate 530 enclose to form a second limiting groove 582. On the other side of the first side plate 510, that is, on a side in the accommodating groove 500, the first side plate 510, the second side plate 520, and the third side plate 530 enclose to form a portion of the accommodating groove 500. The second limiting layer 575 may be located in the second limiting groove 582. The second limiting layer 575 may be embedded into the second limiting groove 582 to prevent the second limiting layer 575 from detaching from a surface of the lifting/lowering block 121.

It may be understood that, when the lifting/lowering block 121 is an integral structure, the second limiting groove 582 may be alternatively a concave structure formed on the surface of the lifting/lowering block 121. The second limiting layer 575 may be embedded into the second limiting groove 582. A shape of the second limiting groove 582 may match a shape of the second limiting layer 575. In some embodiments, the second limiting layer 575 may be in a shape such as a rectangle, an oval, a cone, or a circle. A depth of the second limiting groove 582 may be the same as a thickness of the second limiting layer 575. Alternatively, the depth of the second limiting groove 582 may be slightly greater than the thickness of the second limiting layer 575.

The first side plate 510, the second side plate 520, and the third side plate 530 enclose the inner wall of the accommodating groove 500 to form a first limiting groove 584. In other words, surfaces that are of the first side plate 510, the second side plate 520, and the third side plate 530 and that face the interior of the accommodating groove 500 enclose to form the first limiting groove 584. The first limiting layer 572 is located in the first limiting groove 584. The second limiting groove 582 and the first limiting groove 584 may be respectively located on two sides of the first side plate 510. It may be understood that the first limiting groove 584 may be a portion of the accommodating groove 500. A shape of the first limiting groove 584 may match a shape of the first limiting layer 572, and therefore, the first limiting layer 572 can be prevented from shaking in the accommodating groove 500. Further, a distance between the second side plate 520 and the third side plate 530 may be the same as a width of the first limiting layer 572, to avoid shaking of the first limiting layer 572.

Ends that are of the first side plate 510, the second side plate 520, the third side plate 530, and the fourth side plate 540 and that are away from the bottom plate 550 constitute the inlet 501 of the accommodating groove 500. Ends that are of the first side plate 510, the second side plate 520, the third side plate 530, and the fourth side plate 540 and that face the bottom plate 550 all abut against the surface of the bottom plate 550. In the axial direction of the rotating shaft 320, a length of the second side plate 520 may be the same as a length of the third side plate 530, and a length of the first side plate 510 may be less than the length of the second side plate 520 and the length of the third side plate 530. Therefore, at the inlet 501 of the accommodating groove 500, the first side plate 510 is a short plate, and this is equivalent to that the first side plate 510 is recessed toward the bottom plate 550 to form a limiting port 511. The connecting part 576 may be laid on the limiting port 511 and connect the first limiting layer 572 to the second limiting layer 575. It may be understood that the first side plate 510 may have a specific thickness, and the connecting part 576 may be coated on the first side plate 510 to form an end part of the limiting port 511. The limiting port 511 can also prevent the connecting part 576 from detaching from the limiting port 511.

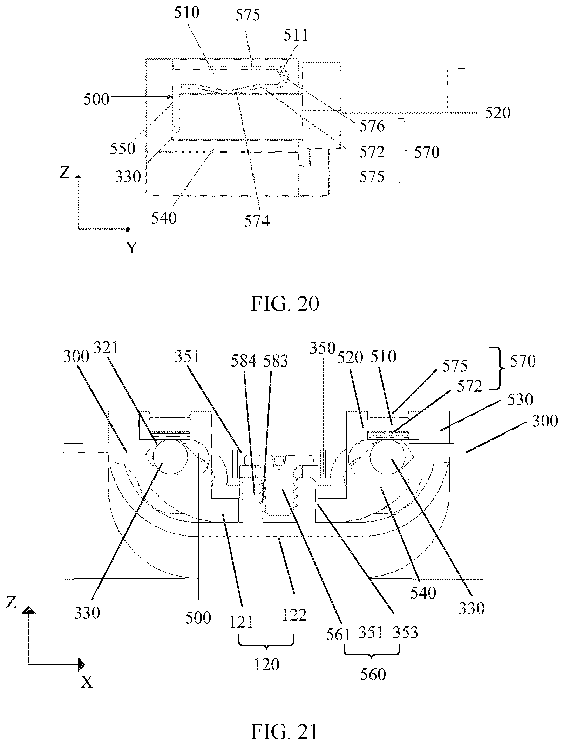

Refer to FIG. 19, FIG. 20, and FIG. 21. FIG. 19 is an exploded view of the lifting/lowering block 121 and the limiting member 570 in an embodiment. FIG. 20 is a schematic diagram of a side cross-section in which the lifting/lowering block 121 fits the limiting member 570 in FIG. 19. FIG. 21 is a schematic diagram of a front cross-section in which the lifting/lowering block 121 fits the limiting member in FIG. 19. In this embodiment, on the basis of the embodiments shown in FIG. 17 and FIG. 18, the materials of the first limiting layer 572, the second limiting layer 575, and the connecting part 576 are changed from rubber to metal. For example, the first limiting layer 572, the second limiting layer 575, and the connecting part 576 may be stainless steel. The first limiting layer 572, the second limiting layer 575, and the connecting part 576 may be connected to each other to form a bent metal sheet structure. The first limiting layer 572 and the second limiting layer 575 may be two ends of the metal sheet structure. The connecting part 576 is a bent portion of the metal sheet structure. The metal sheet structure may have specific elasticity. In some embodiments, the metal sheet structure may use a stainless steel material.

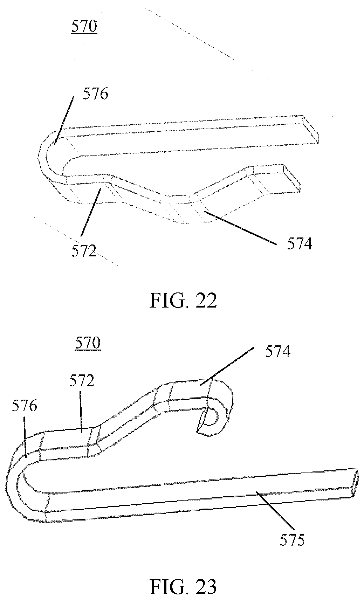

Refer to FIG. 22. FIG. 22 is a schematic diagram of the limiting member 570. A protruding structure 574 protruding toward the interior of the accommodating groove 500 is disposed at the first limiting layer 572, and the protruding structure 574 abuts against the side wall of the centrifugal post. The protruding structure 574 may have specific elasticity, and therefore can achieve a buffering effect for the centrifugal post when the centrifugal post is shaking. In some embodiments, a quantity of protruding structures 574 may be set as required, for example, a plurality of protruding structures 574 that are disposed at intervals may be formed on the surface of the first limiting layer 572, so that a plurality of contact points can be formed for the first limiting layer 572 and the side wall of the centrifugal post, thereby improving contact stability. A manner of forming the protruding structure 574 is not limited. For example, the protruding structure 574 may be formed by bending the first limiting layer 572. In some embodiments, the protruding structure 574 may be formed in a stamping and bending manner.

The protruding structure 574 is disposed on a middle portion of the first limiting layer 572. In other words, the protruding structure 574 may be not located at an end part of the first limiting layer 572. Both ends of the first limiting layer 572 respectively abut against a surface that is of the first side plate 510 and that faces the accommodating groove 500. When the protruding structure 574 is squeezed by the centrifugal post, force may be transferred to the first side plate 510 by using the end part of the first limiting layer 572.

Refer to FIG. 23. FIG. 23 is a schematic diagram of another embodiment of the limiting member 570. In some embodiments, the protruding structure 574 is located at an end that is of the first limiting layer 572 and that is close to the bottom plate 550. The protruding structure 574 may achieve support and shaking buffering effects for the centrifugal post. In some embodiments, an end part in the metal sheet structure may be bent to form the protruding structure 574. An end part of a metal sheet may form a folded structure that is supported on a surface of the first side plate 510, to enhance stability.

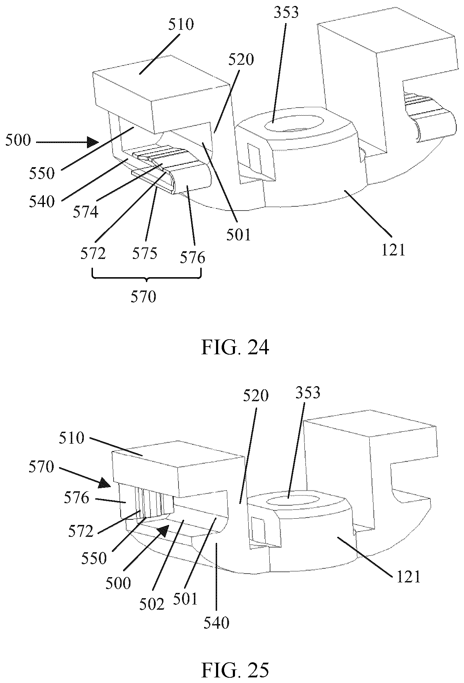

Refer to FIG. 24. FIG. 24 is a schematic diagram in which the limiting member 570 fits the lifting/lowering block 121 in another embodiment. Different from the foregoing embodiment, the first limiting layer 572 may be located on a side that is of the fourth side plate 540 and that faces the interior of the accommodating groove 500, and the second limiting layer 575 may be located on a side that is of the fourth side plate 540 and that is away from the interior of the accommodating groove 500. In other words, the first limiting layer 572 and the second limiting layer 575 are clamped on two opposite surfaces of the fourth side plate 540 by using the connecting part 576.

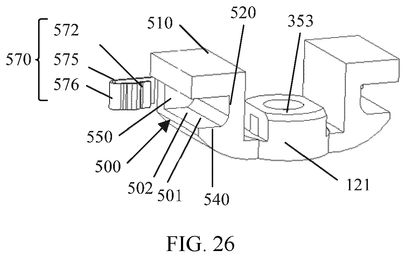

Refer to FIG. 25 and FIG. 26. FIG. 25 is a schematic diagram in which the limiting member 570 fits the lifting/lowering block 121 in another embodiment. FIG. 26 is an exploded view of the embodiment in FIG. 25. Different from the foregoing embodiment, in this embodiment, the first limiting layer 572 is located on a surface that is of the bottom plate 550 and that faces the interior of the accommodating groove 500, and the second limiting layer 575 is located on a surface that is of the bottom plate 550 and that is away from the interior of the accommodating groove 500. The connecting part 576 is connected to the first limiting layer 572 and the second limiting layer 575 through an opening 502 located between the first side plate 510 and the fourth side plate 540.

The second limiting layer 575 may be fastened to an outer wall of the bottom plate 550 in a manner of bonding, welding, or the like. Therefore, the first limiting layer 572 can be prevented from detaching from the bottom plate 550. The first limiting layer 572 can reduce collision caused by the end part of the centrifugal post to a bottom part of the accommodating groove 500, and can also bring damping to rotation of the centrifugal post, thereby improving hand feel of the user during use.

The opening 502 formed between the first side plate 510 and the fourth side plate 540 may be set based on a size. The opening 502 between the first side plate 510 and the fourth side plate 540 may be opposite to the third side plate 530. Same ends of the first side plate 510 and the fourth side plate 540 abut against a surface that is of the second side plate 520 and that faces the interior of the accommodating groove 500. The other ends of the first side plate 510 and the fourth side plate 540 may be free ends and form the opening 502. By using a hole 502, the connecting part 576 may separately connect the first limiting layer 572 and the second limiting layer 575 by bypassing an end that is of the bottom plate 550 and that is away from the second side plate 520. In some embodiments, the connecting part 576 may be embedded at the end that is of the bottom plate 550 and that is away from the second side plate 520, to enhance stability of fitting between the limiting member 570 and the lifting/lowering block 121.

It can be learned from the foregoing embodiment that the lifting/lowering block 121 may be a symmetrical structure. In other words, two accommodating grooves 500 may be symmetrically disposed with respect to the second guide hole 353. The second guide hole 353 may be located on an axis of symmetry of the rotating shaft mechanism 23. The second side plate 520 may be disposed near the second guide hole 353. The opening 502 may be formed on a side that is of the second side plate 520 and that is away from the second guide hole 353. Each accommodating groove 500 may fit one limiting member 570. Because accommodating grooves 500 and limiting members 570 are the same in terms of structures and fitting relationships, details are not described herein again.

It may be understood that "perpendicular" and "parallel" described in the embodiments of this application are not strict "perpendicular" and "parallel" in a mathematical sense, and "perpendicular" herein may be understood as a position relationship of being approximately perpendicular within a range of a manufacture error and an operation error.

In the description of this specification, specific features, structures, materials, or characteristics may be properly combined in any one or more embodiments or examples.

Finally, it should be noted that the foregoing embodiments are only used to describe the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the scope of the technical solutions in embodiments of this application.

## Claims

1. A rotating shaft mechanism (23) for a foldable terminal device, comprising:
a rotating shaft base (110);
a shaft cover assembly (120), disposed on a side of the rotating shaft base (110) in a thickness direction of the rotating shaft base (110), wherein an accommodating groove (500) is disposed in the shaft cover assembly (120);
a rotating shaft (320), rotatably disposed on the rotating shaft base (110);
a centrifugal part (330), fixedly disposed at one end of the rotating shaft (320), wherein the centrifugal part (330) deviates from an axis of the rotating shaft (320), and
the centrifugal part (330) is rotatably disposed in the accommodating groove (500) and is in clearance fit with the accommodating groove (500), and when the rotating shaft (320) rotates, the rotating shaft (320) drives, by using the centrifugal part (330), the shaft cover assembly (120) to move in the thickness direction of the rotating shaft base (110); and a limiting member (570), at least partially located in the accommodating groove (500) and configured to abut against the centrifugal part (330) in rotation.

2. The rotating shaft mechanism (23) according to claim 1, wherein the limiting member (570) comprises a first limiting layer (572), the first limiting layer (572) is disposed on an inner wall of the accommodating groove (500), and the centrifugal part (330) abuts against the first limiting layer (572).

3. The rotating shaft mechanism (23) according to claim 2, wherein the shaft cover assembly (120) comprises a lifting/lowering block (121) and a shaft cover (122) that are fixedly disposed relative to each other, the shaft cover (122) is disposed on a side that is of the lifting/lowering block (121) and that is away from the rotating shaft base (110), and the accommodating groove (500) is disposed on the lifting/lowering block (121).

4. The rotating shaft mechanism (23) according to claim 3, wherein the limiting member (570) further comprises a second limiting layer (575) and a connecting part (576), the second limiting layer (575) is disposed on an outer wall of the lifting/lowering block (121), the inner wall of the accommodating groove (500) is opposite to the outer wall of the lifting/lowering block (121), and the first limiting layer (572) and the second limiting layer (575) are connected by using the connecting part (576).

5. The rotating shaft mechanism (23) according to claim 4, wherein the lifting/lowering block (121) comprises a bottom plate (550) and a first side plate (510), the bottom plate (550) and the first side plate (510) enclose to form at least a portion of the accommodating groove (500), an inlet (501) of the accommodating groove (500) is opposite to the bottom plate (550), a plane on which the first side plate (510) is located extends along the axis of the rotating shaft (320), the first limiting layer (572) is located on a surface that is of the first side plate (510) and that faces an interior of the accommodating groove (500), the second limiting layer (575) is located on a surface that is of the first side plate (510) and that is away from the interior of the accommodating groove (500), and the connecting part (576) is connected to the first limiting layer (572) and the second limiting layer (575) through the inlet (501) of the accommodating groove (500).

6. The rotating shaft mechanism (23) according to claim 5, wherein a protruding structure (574) protruding toward the interior of the accommodating groove (500) is disposed at the first limiting layer (572), and the protruding structure (574) abuts against the centrifugal part (330).

7. The rotating shaft mechanism (23) according to claim 6, wherein the protruding structure (574) is disposed on a middle portion of the first limiting layer (572), and two ends of the first limiting layer (572) separately abut against the surface that is of the first side plate (510) and that faces the accommodating groove (500).

8. The rotating shaft mechanism (23) according to claim 6, wherein the protruding structure (574) is located at one end that is of the first limiting layer (572) and that is close to the bottom plate (550).

9. The rotating shaft mechanism (23) according to any one of claims 5-8, wherein the lifting/lowering block (121) comprises a second side plate (520) and a third side plate (530), planes on which the second side plate (520) and the third side plate (530) are located extend along the axis of the rotating shaft (320) and are respectively located at two opposite ends of the first side plate (510), the bottom plate (550), the first side plate (510), the second side plate (520), and the third side plate (530) enclose to form at least a portion of the accommodating groove (500), the first side plate (510), the second side plate (520), and the third side plate (530) enclose the outer wall of the lifting/lowering block (121) to form a first limiting groove (584), and the second limiting layer (575) is located in the first limiting groove (584); wherein
the bottom plate (550), the first side plate (510), the second side plate (520), and the third side plate (530) enclose the inner wall of the accommodating groove (500) to form a second limiting groove (582), and the first limiting layer (572) is located in the second limiting groove (582).

10. The rotating shaft mechanism (23) according to any one of claims 5-9, wherein at the inlet (501) of the accommodating groove (500), the first side plate (510) is recessed toward the bottom plate (550) to form a limiting port (511), and the connecting part (576) is located on the limiting port (511).

11. The rotating shaft mechanism (23) according to claim 4, wherein the lifting/lowering block (121) comprises a bottom plate (550), a first side plate (510), and a fourth side plate (540), an inlet (501) of the accommodating groove (500) is opposite to the bottom plate (550), a plane on which the first side plate (510) is located and a plane on which the fourth side plate (540) is located extend along the axis of the rotating shaft (320), the fourth side plate (540) is opposite to the first side plate (510), and the bottom plate (550), the first side plate (510), and the fourth side plate (540) enclose to form at least a portion of the accommodating groove (500); and
the first limiting layer (572) is located on a surface that is of the bottom plate (550) and that faces an interior of the accommodating groove (500), the second limiting layer (575) is located on a surface that is of the bottom plate (550) and that is away from the interior of the accommodating groove (500), and the connecting part (576) is connected to the first limiting layer (572) and the second limiting layer (575) through an opening located between the first side plate (510) and the fourth side plate (540).

12. The rotating shaft mechanism (23) according to claim 2, wherein the inner wall of the accommodating groove (500) comprises a bottom wall and a side wall, the bottom wall of the accommodating groove (500) is opposite to an inlet (501) of the accommodating groove (500), the side wall extends along the axis of the rotating shaft (320), and the first limiting layer (572) is disposed on the bottom wall of the accommodating groove (500); and
two limiting steps (512) are disposed at an interval on the bottom wall of the accommodating groove (500), and the first limiting layer (572) is sandwiched between the two limiting steps (512).

13. The rotating shaft mechanism (23) according to claim 2, wherein the inner wall of the accommodating groove (500) comprises a bottom wall and a side wall, the bottom wall of the accommodating groove (500) is opposite to an inlet (501) of the accommodating groove (500), the side wall extends along the axis of the rotating shaft (320), and the first limiting layer (572) is disposed on the side wall; and
a third limiting groove (573) is disposed on a surface that is of the first limiting layer (572) and that faces an interior of the accommodating groove (500), and the third limiting groove (573) extends in a direction in which the rotating shaft (320) extends.

14. The rotating shaft mechanism (23) according to any one of claims 1-13, wherein the centrifugal part (330) comprises a centrifugal post, the centrifugal post is fixedly disposed at one end of the rotating shaft (320), an axis of the centrifugal post is parallel to the axis of the rotating shaft (320), a width of the accommodating groove (500) is greater than a diameter of the centrifugal post, a width direction of the accommodating groove (500) is separately perpendicular to the axis of the rotating shaft (320) and the thickness direction of the rotating shaft base (110), and the axis of the rotating shaft (320) is perpendicular to the thickness direction of the rotating shaft base (110); and
when the centrifugal post rotates around the axis of the rotating shaft (320), a maximum displacement difference of the centrifugal post in the thickness direction of the rotating shaft base (110) is a first distance, a height of the accommodating groove (500) in the thickness direction of the rotating shaft base (110) is a second distance, and the first distance is greater than the second distance.

15. A foldable terminal device (100), comprising the rotating shaft mechanism (23) according to any one of claims 1-14.

## Patentansprüche

1. Eine Rotationswellenmechanik (23) für ein faltbares Endgerät, umfassend:
einen Rotationswellen-Grundkörper (110);
eine Wellenabdeckungs-Baugruppe (120), angeordnet an einer Seite des Rotationswellen-Grundkörpers (110) in Richtung der Dicke des Rotationswellen-Grundkörpers (110), wobei in der Wellenabdeckungs-Baugruppe (120) eine Aufnahmenut (500) vorgesehen ist;
eine Rotationswelle (320), drehbar am Rotationswellen-Grundkörper (110) angebracht;
ein Zentrifugalteil (330), fest an einem Ende der Rotationswelle (320) angebracht, wobei das Zentrifugalteil (330) von der Achse der Rotationswelle (320) abweicht, und
das Zentrifugalteil (330) ist drehbar in der Aufnahmenut (500) gelagert und befindet sich im Spielpassung mit der Aufnahmenut (500), und beim Drehen der Rotationswelle (320) bewegt die Rotationswelle (320) mithilfe des Zentrifugalteils (330) die Wellenabdeckungs-Baugruppe (120) in der Dicke-Richtung des Rotationswellen-Grundkörpers (110); sowie ein Begrenzungselement (570), das sich zumindest teilweise in der Aufnahmenut (500) befindet und dafür ausgelegt ist, im Drehbetrieb gegen das Zentrifugalteil (330) zu stoßen.

2. Rotationswellenmechanik (23) gemäß Anspruch 1, wobei das Begrenzungselement (570) eine erste Begrenzungsschicht (572) umfasst, wobei die erste Begrenzungsschicht (572) an einer Innenwand der Aufnahmenut (500) angebracht ist und das Zentrifugalteil (330) gegen die erste Begrenzungsschicht (572) stößt.

3. Rotationswellenmechanik (23) gemäß Anspruch 2, wobei die Wellenabdeckungs-Baugruppe (120) einen Hub-/Senkblock (121) und eine Wellenabdeckung (122) umfasst, die fest relativ zueinander angeordnet sind, wobei die Wellenabdeckung (122) an der dem Rotationswellen-Grundkörper (110) abgewandten Seite des Hub-/Senkblocks (121) angebracht ist und die Aufnahmenut (500) am Hub-/Senkblock (121) vorgesehen ist.

4. Rotationswellenmechanik (23) gemäß Anspruch 3, wobei das Begrenzungselement (570) zudem eine zweite Begrenzungsschicht (575) sowie ein Verbindungsteil (576) umfasst, wobei die zweite Begrenzungsschicht (575) an einer Außenwand des Hub-/Senkblocks (121) angebracht ist, die Innenwand der Aufnahmenut (500) gegenüber der Außenwand des Hub-/Senkblocks (121) liegt, und die erste Begrenzungsschicht (572) sowie die zweite Begrenzungsschicht (575) mittels des Verbindungsteils (576) miteinander verbunden sind.

5. Rotationswellenmechanismus (23) nach Anspruch 4, wobei der Hub-/Senkblock (121) eine Bodenplatte (550) und eine erste Seitenplatte (510) umfasst, wobei die Bodenplatte (550) und die erste Seitenplatte (510) gemeinsam zumindest einen Teil der Aufnahmerille (500) umschließen, wobei eine Öffnung (501) der Aufnahmerille (500) der Bodenplatte (550) gegenüberliegt und die Ebene, in der sich die erste Seitenplatte (510) befindet, sich entlang der Achse der Rotationswelle (320) erstreckt, wobei die erste Begrenzungsschicht (572) auf einer Fläche der ersten Seitenplatte (510) angeordnet ist, die dem Inneren der Aufnahmerille (500) zugewandt ist, die zweite Begrenzungsschicht (575) auf einer Fläche der ersten Seitenplatte (510) angeordnet ist, die vom Inneren der Aufnahmerille (500) abgewandt ist, und das Verbindungsteil (576) über die Öffnung (501) der Aufnahmerille (500) mit der ersten Begrenzungsschicht (572) und der zweiten Begrenzungsschicht (575) verbunden ist.

6. Rotationswellenmechanismus (23) nach Anspruch 5, wobei an der ersten Begrenzungsschicht (572) eine in Richtung des Inneren der Aufnahmerille (500) vorspringende Struktur (574) angeordnet ist, und die vorspringende Struktur (574) an dem Zentrifugalteil (330) anliegt.

7. Rotationswellenmechanismus (23) nach Anspruch 6, wobei die vorspringende Struktur (574) auf einem mittleren Bereich der ersten Begrenzungsschicht (572) angeordnet ist und die beiden Enden der ersten Begrenzungsschicht (572) getrennt voneinander an die Fläche der ersten Seitenplatte (510) anliegen, die der Aufnahmerille (500) zugewandt ist.

8. Rotationswellenmechanismus (23) nach Anspruch 6, wobei die vorspringende Struktur (574) an einem Ende der ersten Begrenzungsschicht (572) angeordnet ist, das der Bodenplatte (550) nahe liegt.

9. Rotationswellenmechanismus (23) nach einem der Ansprüche 5-8, wobei der Hub-/Senkblock (121) eine zweite Seitenplatte (520) und eine dritte Seitenplatte (530) umfasst, die Ebenen, auf denen sich die zweite Seitenplatte (520) und die dritte Seitenplatte (530) befinden, sich entlang der Achse der Rotationswelle (320) erstrecken und jeweils an zwei gegenüberliegenden Enden der ersten Seitenplatte (510) angeordnet sind, wobei die Bodenplatte (550), die erste Seitenplatte (510), die zweite Seitenplatte (520) und die dritte Seitenplatte (530) gemeinsam zumindest einen Teil der Aufnahmerille (500) umschließen, wobei die erste Seitenplatte (510), die zweite Seitenplatte (520) und die dritte Seitenplatte (530) die Außenwand des Hub-/Senkblocks (121) gemeinsam umschließen, um eine erste Begrenzungsrille (584) zu bilden, und die zweite Begrenzungsschicht (575) sich in der ersten Begrenzungsrille (584) befindet; wobei
Die Bodenplatte (550), die erste Seitenplatte (510), die zweite Seitenplatte (520) und die dritte Seitenplatte (530) umschließen die Innenwand der Aufnahmerinne (500) und bilden eine zweite Begrenzungsnut (582), wobei sich die erste Begrenzungsschicht (572) in der zweiten Begrenzungsnut (582) befindet.

10. Die Rotationswellenmechanik (23) gemäß einem der Ansprüche 5-9, wobei am Einlass (501) der Aufnahmerinne (500) die erste Seitenplatte (510) zur Bodenplatte (550) hin zurückgesetzt ist, um eine Begrenzungsöffnung (511) zu bilden, und das Verbindungsteil (576) befindet sich an der Begrenzungsöffnung (511).

11. Die Rotationswellenmechanik (23) gemäß Anspruch 4, wobei der Hebe-/Senkklotz (121) eine Bodenplatte (550), eine erste Seitenplatte (510) und eine vierte Seitenplatte (540) umfasst, wobei ein Einlass (501) der Aufnahmerinne (500) der Bodenplatte (550) gegenüberliegt, eine Ebene, auf der sich die erste Seitenplatte (510) befindet, und eine Ebene, auf der sich die vierte Seitenplatte (540) befindet, entlang der Achse der Rotationswelle (320) verlaufen, die vierte Seitenplatte (540) der ersten Seitenplatte (510) gegenüberliegt und die Bodenplatte (550), die erste Seitenplatte (510) sowie die vierte Seitenplatte (540) einen zumindest teilweisen Abschluss der Aufnahmerinne (500) bilden; und
Die erste Begrenzungsschicht (572) befindet sich auf einer Oberfläche der Bodenplatte (550), die zum Inneren der Aufnahmerinne (500) zeigt, die zweite Begrenzungsschicht (575) befindet sich auf einer Oberfläche der Bodenplatte (550), die vom Inneren der Aufnahmerinne (500) abgewandt ist, und das Verbindungsteil (576) ist durch eine zwischen der ersten Seitenplatte (510) und der vierten Seitenplatte (540) angeordnete Öffnung mit der ersten Begrenzungsschicht (572) und der zweiten Begrenzungsschicht (575) verbunden.

12. Die Rotationswellenmechanik (23) gemäß Anspruch 2, wobei die Innenwand der Aufnahmerinne (500) eine Bodenwand und eine Seitenwand umfasst, die Bodenwand der Aufnahmerinne (500) dem Einlass (501) der Aufnahmerinne (500) gegenüberliegt, die Seitenwand entlang der Achse der Rotationswelle (320) verläuft und die erste Begrenzungsschicht (572) auf der Bodenwand der Aufnahmerinne (500) angeordnet ist; und
Zwei Begrenzungsstufen (512) sind mit Abstand auf der Bodenwand der Aufnahmerinne (500) angeordnet und die erste Begrenzungsschicht (572) ist zwischen den beiden Begrenzungsstufen (512) eingefasst.

13. Die Rotationswellenmechanik (23) gemäß Anspruch 2, wobei die Innenwand der Aufnahmerinne (500) eine Bodenwand und eine Seitenwand umfasst, die Bodenwand der Aufnahmerinne (500) dem Einlass (501) der Aufnahmerinne (500) gegenüberliegt, die Seitenwand entlang der Achse der Rotationswelle (320) verläuft und die erste Begrenzungsschicht (572) auf der Seitenwand angeordnet ist; und
Eine dritte Begrenzungsnut (573) ist auf einer Oberfläche der ersten Begrenzungsschicht (572) angeordnet, die dem Inneren der Aufnahmenut (500) zugewandt ist, und die dritte Begrenzungsnut (573) verläuft in einer Richtung, in der sich die Rotationsachse (320) erstreckt.

14. Der Rotationsachsenmechanismus (23) nach einem der Ansprüche 1-13, wobei der Zentrifugalteil (330) einen Zentrifugalpfosten umfasst, der Zentrifugalpfosten fest an einem Ende der Rotationsachse (320) angeordnet ist, die Achse des Zentrifugalpfostens parallel zur Achse der Rotationsachse (320) verläuft, die Breite der Aufnahmenut (500) größer ist als der Durchmesser des Zentrifugalpfostens, die Breitenrichtung der Aufnahmenut (500) sowohl senkrecht zur Achse der Rotationsachse (320) als auch zur Dickenrichtung der Rotationsachsenbasis (110) verläuft, und die Achse der Rotationsachse (320) senkrecht zur Dickenrichtung der Rotationsachsenbasis (110) steht; und
Wenn sich der Zentrifugalpfosten um die Achse der Rotationsachse (320) dreht, beträgt der maximale Verschiebungsunterschied des Zentrifugalpfostens in der Dickenrichtung der Rotationsachsenbasis (110) eine erste Entfernung, die Höhe der Aufnahmenut (500) in der Dickenrichtung der Rotationsachsenbasis (110) eine zweite Entfernung, und die erste Entfernung ist größer als die zweite Entfernung.

15. Eine faltbare Endgerätevorrichtung (100), die den Rotationsachsenmechanismus (23) gemäß einem der Ansprüche 1-14 umfasst.

## Revendications

1. Un mécanisme d'arbre rotatif (23) pour un dispositif terminal pliable, comprenant :
une base d'arbre rotatif (110) ;
un ensemble couvercle d'arbre (120), disposé sur un côté de la base d'arbre rotatif (110) dans la direction de l'épaisseur de la base d'arbre rotatif (110), dans lequel une rainure d'accueil (500) est disposée dans l'ensemble couvercle d'arbre (120) ;
un arbre rotatif (320), monté de façon rotative sur la base d'arbre rotatif (110) ;
une partie centrifuge (330), fixée à une extrémité de l'arbre rotatif (320), la partie centrifuge (330) s'écartant de l'axe de l'arbre rotatif (320), et
la partie centrifuge (330) est montée rotative dans la rainure d'accueil (500) et présente un ajustement avec jeu avec la rainure d'accueil (500) ; lorsque l'arbre rotatif (320) tourne, l'arbre rotatif (320) entraîne, en utilisant la partie centrifuge (330), l'ensemble couvercle d'arbre (120) à se déplacer dans la direction de l'épaisseur de la base d'arbre rotatif (110) ; et un élément de limitation (570), situé au moins partiellement dans la rainure d'accueil (500) et conçu pour venir en butée contre la partie centrifuge (330) lors de la rotation.

2. Le mécanisme d'arbre rotatif (23) selon la revendication 1, dans lequel l'élément de limitation (570) comprend une première couche de limitation (572), la première couche de limitation (572) étant disposée sur une paroi intérieure de la rainure d'accueil (500), et la partie centrifuge (330) venant en butée contre la première couche de limitation (572).

3. Le mécanisme d'arbre rotatif (23) selon la revendication 2, dans lequel l'ensemble couvercle d'arbre (120) comprend un bloc de levage/abaissement (121) et un couvercle d'arbre (122) qui sont fixés l'un par rapport à l'autre, le couvercle d'arbre (122) étant disposé sur un côté du bloc de levage/abaissement (121) éloigné de la base d'arbre rotatif (110), et la rainure d'accueil (500) étant disposée sur le bloc de levage/abaissement (121).

4. Le mécanisme d'arbre rotatif (23) selon la revendication 3, dans lequel l'élément de limitation (570) comprend en outre une seconde couche de limitation (575) et une partie de connexion (576), la seconde couche de limitation (575) étant disposée sur une paroi extérieure du bloc de levage/abaissement (121), la paroi intérieure de la rainure d'accueil (500) étant opposée à la paroi extérieure du bloc de levage/abaissement (121), et la première couche de limitation (572) et la seconde couche de limitation (575) étant reliées par la partie de connexion (576).

5. Le mécanisme d'arbre rotatif (23) selon la revendication 4, dans lequel le bloc de levage/abaissement (121) comprend une plaque inférieure (550) et une première plaque latérale (510), la plaque inférieure (550) et la première plaque latérale (510) délimitant au moins une partie de la gorge d'accueil (500), une entrée (501) de la gorge d'accueil (500) faisant face à la plaque inférieure (550), un plan sur lequel se situe la première plaque latérale (510) s'étendant le long de l'axe de l'arbre rotatif (320), la première couche de limitation (572) se trouve sur une surface de la première plaque latérale (510) faisant face à l'intérieur de la gorge d'accueil (500), la deuxième couche de limitation (575) se trouve sur une surface de la première plaque latérale (510) opposée à l'intérieur de la gorge d'accueil (500), et la partie de raccordement (576) est reliée à la première couche de limitation (572) et à la deuxième couche de limitation (575) par l'entrée (501) de la gorge d'accueil (500).

6. Le mécanisme d'arbre rotatif (23) selon la revendication 5, dans lequel une structure en saillie (574) faisant saillie vers l'intérieur de la gorge d'accueil (500) est disposée au niveau de la première couche de limitation (572), et la structure en saillie (574) est en appui contre la partie centrifuge (330).

7. Le mécanisme d'arbre rotatif (23) selon la revendication 6, dans lequel la structure en saillie (574) est disposée sur une partie médiane de la première couche de limitation (572), et les deux extrémités de la première couche de limitation (572) prennent appui séparément contre la surface de la première plaque latérale (510) faisant face à la gorge d'accueil (500).

8. Le mécanisme d'arbre rotatif (23) selon la revendication 6, dans lequel la structure en saillie (574) est située à une extrémité de la première couche de limitation (572) proche de la plaque inférieure (550).

9. Le mécanisme d'arbre rotatif (23) selon l'une quelconque des revendications 5 à 8, dans lequel le bloc de levage/abaissement (121) comprend une deuxième plaque latérale (520) et une troisième plaque latérale (530), les plans sur lesquels se trouvent la deuxième plaque latérale (520) et la troisième plaque latérale (530) s'étendent le long de l'axe de l'arbre rotatif (320) et sont respectivement situés à deux extrémités opposées de la première plaque latérale (510), la plaque inférieure (550), la première plaque latérale (510), la deuxième plaque latérale (520) et la troisième plaque latérale (530) délimitant ensemble au moins une partie de la gorge d'accueil (500), la première plaque latérale (510), la deuxième plaque latérale (520) et la troisième plaque latérale (530) entourant la paroi extérieure du bloc de levage/abaissement (121) pour former une première gorge de limitation (584), et la deuxième couche de limitation (575) étant située dans la première gorge de limitation (584); dans lequel
la plaque inférieure (550), la première plaque latérale (510), la deuxième plaque latérale (520) et la troisième plaque latérale (530) entourent la paroi interne de la rainure de logement (500) pour former une deuxième rainure de limitation (582), et la première couche de limitation (572) est située dans la deuxième rainure de limitation (582).

10. Le mécanisme d'arbre rotatif (23) selon l'une quelconque des revendications 5 à 9, dans lequel, à l'entrée (501) de la rainure de logement (500), la première plaque latérale (510) est en retrait vers la plaque inférieure (550) pour former un orifice de limitation (511), et la partie de connexion (576) est située sur l'orifice de limitation (511).

11. Le mécanisme d'arbre rotatif (23) selon la revendication 4, dans lequel le bloc de levage/abaissement (121) comprend une plaque inférieure (550), une première plaque latérale (510) et une quatrième plaque latérale (540), l'entrée (501) de la rainure de logement (500) faisant face à la plaque inférieure (550), un plan dans lequel se trouve la première plaque latérale (510) et un plan dans lequel se trouve la quatrième plaque latérale (540) s'étendent le long de l'axe de l'arbre rotatif (320), la quatrième plaque latérale (540) faisant face à la première plaque latérale (510), et la plaque inférieure (550), la première plaque latérale (510) et la quatrième plaque latérale (540) entourent pour former au moins une partie de la rainure de logement (500) ; et
la première couche de limitation (572) est située sur une surface de la plaque inférieure (550) qui fait face à l'intérieur de la rainure de logement (500), la deuxième couche de limitation (575) est située sur une surface de la plaque inférieure (550) qui est opposée à l'intérieur de la rainure de logement (500), et la partie de connexion (576) est connectée à la première couche de limitation (572) et à la deuxième couche de limitation (575) par une ouverture située entre la première plaque latérale (510) et la quatrième plaque latérale (540).

12. Le mécanisme d'arbre rotatif (23) selon la revendication 2, dans lequel la paroi intérieure de la rainure de logement (500) comprend une paroi inférieure et une paroi latérale, la paroi inférieure de la rainure de logement (500) fait face à une entrée (501) de la rainure de logement (500), la paroi latérale s'étend le long de l'axe de l'arbre rotatif (320), et la première couche de limitation (572) est disposée sur la paroi inférieure de la rainure de logement (500) ; et
deux étapes de limitation (512) sont disposées à intervalles sur la paroi inférieure de la rainure de logement (500), et la première couche de limitation (572) est prise en sandwich entre les deux étapes de limitation (512).

13. Le mécanisme d'arbre rotatif (23) selon la revendication 2, dans lequel la paroi intérieure de la rainure de logement (500) comprend une paroi inférieure et une paroi latérale, la paroi inférieure de la rainure de logement (500) fait face à une entrée (501) de la rainure de logement (500), la paroi latérale s'étend le long de l'axe de l'arbre rotatif (320), et la première couche de limitation (572) est disposée sur la paroi latérale ; et
une troisième rainure de limitation (573) est disposée sur une surface de la première couche limitante (572), laquelle fait face à l'intérieur de la rainure d'accueil (500), et la troisième rainure de limitation (573) s'étend dans la direction d'extension de l'arbre rotatif (320).

14. Le mécanisme d'arbre rotatif (23) selon l'une quelconque des revendications 1 à 13, dans lequel la partie centrifuge (330) comprend un axe centrifuge, l'axe centrifuge étant fixé à une extrémité de l'arbre rotatif (320), l'axe de ce dernier étant parallèle à l'axe de l'arbre rotatif (320), la largeur de la rainure d'accueil (500) étant supérieure au diamètre de l'axe centrifuge, la direction de largeur de la rainure d'accueil (500) étant perpendiculaire respectivement à l'axe de l'arbre rotatif (320) et à la direction d'épaisseur de la base d'arbre rotatif (110), et l'axe de l'arbre rotatif (320) étant perpendiculaire à la direction d'épaisseur de la base de l'arbre rotatif (110) ; et
lorsque l'axe centrifuge tourne autour de l'axe de l'arbre rotatif (320), la différence maximale de déplacement de l'axe centrifuge dans la direction d'épaisseur de la base de l'arbre rotatif (110) correspond à une première distance, la hauteur de la rainure d'accueil (500) dans la direction d'épaisseur de la base de l'arbre rotatif (110) correspond à une seconde distance, et la première distance est supérieure à la seconde distance.

15. Un dispositif terminal pliable (100), comprenant le mécanisme d'arbre rotatif (23) selon l'une quelconque des revendications 1 à 14.
